# EUROPEAN PATENT APPLICATION

(11) **EP 3 048 646 A1**
(43) Date of publication of application: **27.07.2016**
(21) Application number: 15183862.0
(22) Date of filing: 04.09.2015
(51) Int. Cl.: H01L 27/15, C08K 3/22, H01C 7/105, H01C 7/112, H01L 23/00, H01L 33/56, H01L 33/48

(54) **COMPOSITE RESIN AND ELECTRONIC DEVICE**

(30) Priority: 22.01.2015 JP 2015010596
(71) Applicant: Kabushiki Kaisha Toshiba, Tokyo 105-8001 (JP)
(72) Inventor: Sugizaki, Yoshiaki, Tokyo, 105-8001 (JP)
(74) Representative: Hoffmann Eitle

(57) **Abstract**

According to one embodiment, a composite resin includes a resin component (51); a plurality of first powder bodies (52) dispersed in the resin component (51), and having a nonlinear current-voltage characteristic having a decreasing resistance as a voltage increases; and a plurality of second powder bodies (57) dispersed in the resin component (51), and having electrical conductivity. The plurality of first powder bodies (52) is a polycrystalline powder body including a plurality of primary particles (53) bound via a grain boundary (54), a component different from a main component of the plurality of primary particles (53) being present. A work function of the plurality of second powder bodies (57) is not more than a work function of the plurality of primary particles (53).

## Description

### FIELD

Embodiments described herein relate generally to a composite resin and an electronic device.

### BACKGROUND

Various structures for protecting electronic devices such as an LED (Light Emitting Diode) from ESD (Electro Static Discharge) have been proposed, however, particularly, electronic devices having a chip-size package structure are required to have ESD resistance without hindering miniaturization.

### BRIEF DESCRIPTION OF THE DRAWINGS

FIG. 1 to FIG. 5 are schematic cross-sectional views of a semiconductor light emitting device of a first embodiment;
FIG. 6A to FIG. 6C are schematic views of the first powder bodies;
FIG. 7 to FIG. 9 are flowcharts showing a method for manufacturing first powder bodies;
FIG. 10A to FIG. 20B are schematic views showing a method for manufacturing the semiconductor light emitting device of the first embodiment;
FIG. 21A and FIG. 21B are schematic cross-sectional views of a semiconductor light emitting device of a second embodiment;
FIG. 22A to FIG. 23C are schematic cross-sectional views showing a method for manufacturing the semiconductor light emitting device of the second embodiment;
FIG. 24A and FIG. 24B are schematic views of a semiconductor device of a third embodiment;
FIG. 25 is a current-voltage characteristic chart of the first powder bodies;
FIG. 26 to FIG. 30 are schematic cross-sectional views of a semiconductor light emitting device of the first embodiment; and
FIG. 31A and FIG. 31B are schematic cross-sectional views of a semiconductor light emitting device of a fourth embodiment.

### DETAILED DESCRIPTION

According to one embodiment, a composite resin includes a resin component; a plurality of first powder bodies dispersed in the resin component, and having a nonlinear current-voltage characteristic having a decreasing resistance as a voltage increases; and a plurality of second powder bodies dispersed in the resin component, and having electrical conductivity. The plurality of first powder bodies is a polycrystalline powder body including a plurality of primary particles bound via a grain boundary, a component different from a main component of the plurality of primary particles being present. A work function of the plurality of second powder bodies is not more than a work function of the plurality of primary particles.

Embodiments are described below with reference to the drawings. Note that in the drawings, the same components are denoted by the same reference numerals and signs.

### (First Embodiment)

In a first embodiment, a description will be made by showing a semiconductor light emitting device (LED device) as one example of an electronic device.

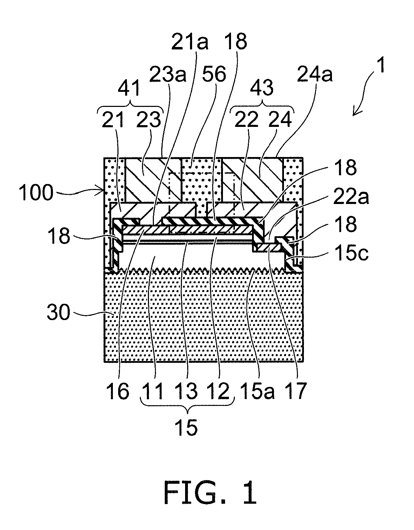

FIG. 1 is a schematic cross-sectional view of a semiconductor light emitting device 1 of the first embodiment.

The semiconductor light emitting device 1 has a semiconductor layer 15 including a light emitting layer 13. The semiconductor layer 15 has a first face 15a and a second face on an opposite side thereof. The semiconductor layer 15 on the second face side is processed into a mesa shape.

The second face of the semiconductor layer 15 has a portion including the light emitting layer 13 (light emitting region) and a portion including no light emitting layer 13. The portion including the light emitting layer 13 is a portion in which the light emitting layer 13 is stacked in the semiconductor layer 15. The portion including no light emitting layer 13 is a portion in which the light emitting layer 13 is not stacked in the semiconductor layer 15. The portion including the light emitting layer 13 is a light emitting region and is a region which has the light emitting layer 13 and also has a stacked structure capable of extracting an emitted light from the light emitting layer 13 to the outside.

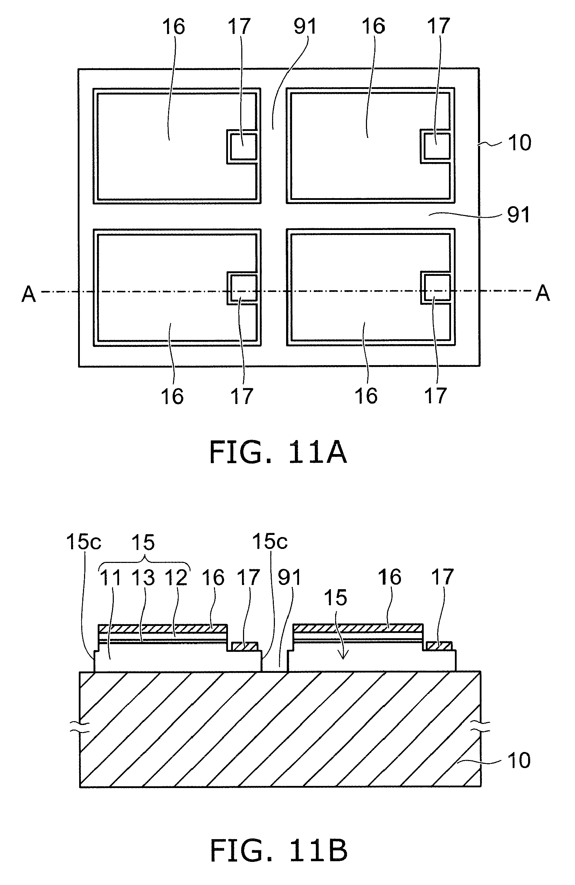

A p-side electrode 16 and an n-side electrode 17 are provided on the second face side. For example, on the second face side, on the portion including the light emitting layer 13, the p-side electrode 16 is provided as a first electrode, and on the portion including no light emitting layer, the n-side electrode 17 is provided as a second electrode. For example, in a planar view shown in FIG. 11A, three sides of the n-side electrode 17 in a rectangular shape are surrounded by the p-side electrode 16. Incidentally, a planar layout of the p-side electrode 16 and the n-side electrode 17 is not limited to the example shown in FIG. 11A.

An electric current is supplied to the light emitting layer 13 through the p-side electrode 16 and the n-side electrode 17, and the light emitting layer 13 emits light. A light emitted from the light emitting layer 13 is emitted outside the semiconductor light emitting device 1 from the first face 15a side.

As shown in FIG. 1, on the second face side of the semiconductor layer 15, a support 100 is provided. An LED chip including the semiconductor layer 15, the p-side electrode 16 and the n-side electrode 17 is supported by the support 100 provided on the second face side.

On the first face 15a side of the semiconductor layer 15, for example, a phosphor layer 30 is provided as an optical layer which imparts a desired optical characteristic to an emitted light from the semiconductor light emitting device 1. The phosphor layer 30 includes a plurality of phosphors. The phosphor is excited by an emitted light from the light emitting layer 13 and emits a light having a wavelength different from that of the emitted light.

The plurality of phosphors is integrated with one another with a binder. The binder transmits the emitted light from the light emitting layer 13 and the emitted light from the phosphors. The term "transmit" as used herein is not limited to a case where the transmittance is 100%, but also includes a case where a light is partially absorbed.

The semiconductor layer 15 includes a first semiconductor layer 11, a second semiconductor layer 12, and the light emitting layer 13. The first semiconductor layer 11 and the second semiconductor layer 12 contain, for example, gallium nitride (GaN).

The first semiconductor layer 11 includes, for example, a foundation buffer layer and an n-type GaN layer. The second semiconductor layer 12 includes, for example, a p-type GaN layer. The light emitting layer 13 contains a material which emits a light such as a blue, purple, bluish purple, or ultraviolet light. An emission peak wavelength of the light emitting layer 13 is, for example, from 430 to 470 nm.

The second face of the semiconductor layer 15 is processed into a concave-convex shape. A convex portion thereof is a portion including the light emitting layer 13, and a concave portion thereof is a portion including no light emitting layer 13. A surface of the portion including the light emitting layer 13 is a surface of the second semiconductor layer 12, and the p-side electrode 16 is provided on the surface of the second semiconductor layer 12. A surface of the portion including no light emitting layer 13 is a surface of the first semiconductor layer 11, and the n-side electrode 17 is provided on the surface of the first semiconductor layer 11.

For example, on the second face of the semiconductor layer 15, an area of the portion including the light emitting layer 13 is larger than an area of the portion including no light emitting layer 13. Further, an area of the p-side electrode 16 provided on the surface of the portion including the light emitting layer 13 is larger than an area of the n-side electrode 17 provided on the surface of the portion including no light emitting layer 13. According to this, a large light emitting face is obtained, and thus, the light output can be increased.

On the second face side of the semiconductor layer 15, an insulating film 18 is provided as a first insulating film. The insulating film 18 covers and protects the second face of the semiconductor layer 15, the p-side electrode 16, and the n-side electrode 17. The insulating film 18 is, for example, an inorganic insulating film such as a silicon oxide film.

The insulating film 18 is also provided on a side surface of the light emitting layer 13 and a side surface of the second semiconductor layer 12, and covers and protects these side surfaces.

Further, the insulating film 18 is also provided on a side surface (a side surface of the first semiconductor layer 11) 15c continuous with the first face 15a of the semiconductor layer 15, and covers and protects the side surface 15c.

Further, the insulating film 18 is also provided in a peripheral region of the side surface 15c of the semiconductor layer 15. The insulating film 18 provided in the peripheral region of the side surface 15c extends from the side surface 15c on the first face 15a side to an opposite side (an outside of the semiconductor light emitting device 1) to the side surface 15c.

On the insulating film 18, a p-side interconnect layer 21 as a first interconnect layer and an n-side interconnect layer 22 as a second interconnect layer are provided spaced apart from each other.

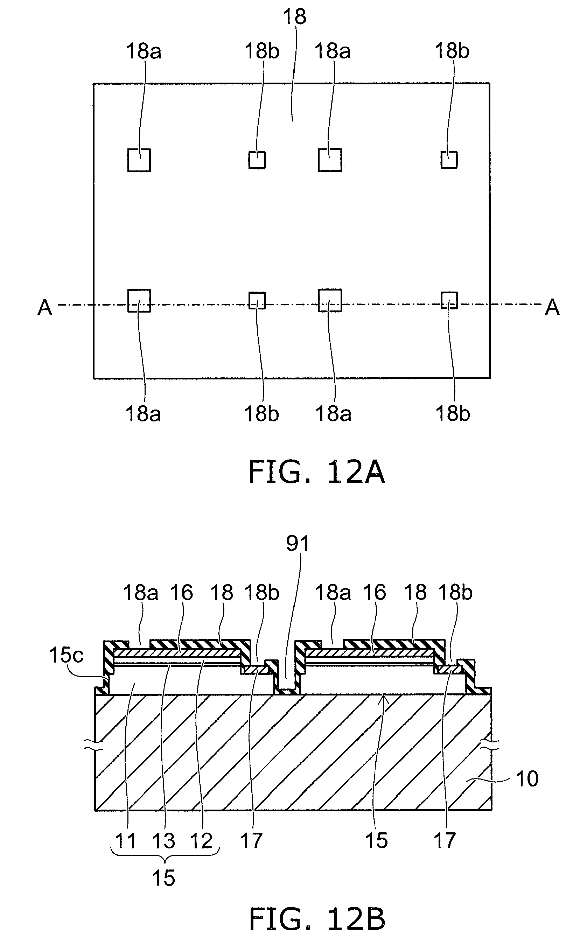

As shown in FIGS. 12A and 12B, in the insulating film 18, a first opening 18a communicating with the p-side electrode 16 and a second opening 18b communicating with the n-side electrode 17 are formed. Incidentally, a plurality of the first openings 18a may be formed.

The p-side interconnect layer 21 is provided on the insulating film 18 and inside the first opening 18a. The p-side interconnect layer 21 is electrically connected to the p-side electrode 16 through a via 21a provided in the first opening 18a. The n-side interconnect layer 22 is provided on the insulating film 18 and inside the second opening 18b. The n-side interconnect layer 22 is electrically connected to the n-side electrode 17 through a via 22a provided in the second opening 18b.

The p-side interconnect layer 21 and the n-side interconnect layer 22 include a copper film formed simultaneously by, for example, a plating method on a shared foundation metal film.

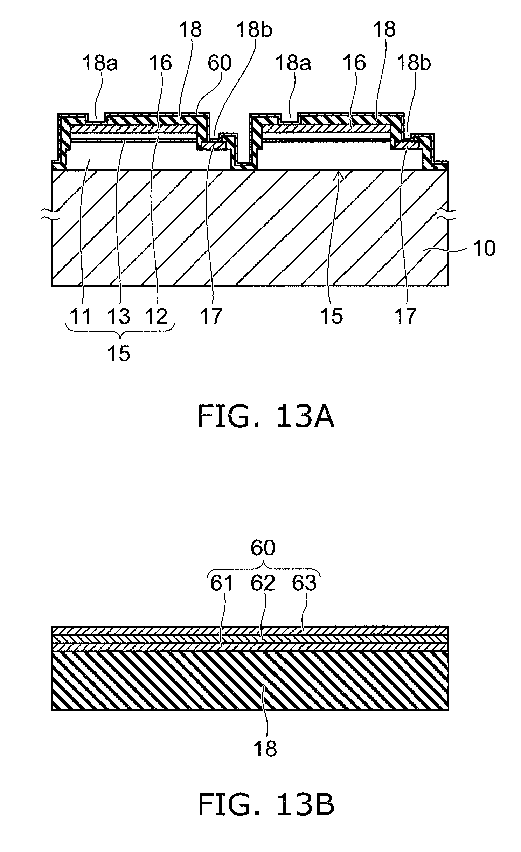

FIG. 13B is a schematic cross-sectional view of the foundation metal film 60.

For example, a copper film constituting the p-side interconnect layer 21 and the n-side interconnect layer 22 is formed by a plating method on the foundation metal film 60 formed on the insulating film 18. The p-side interconnect layer 21 and the n-side interconnect layer 22 are constituted including this foundation metal film 60.

The foundation metal film 60 has an aluminum (Al) film 61, a titanium (Ti) film 62, and a copper (Cu) film 63, which are stacked in this order from the insulating film 18 side.

The aluminum film 61 functions as a reflective film, and the copper film 63 functions as a seed layer for plating. The titanium film 62 has excellent wettability to aluminum and copper, the titanium film 62 functions as an adhesion layer.

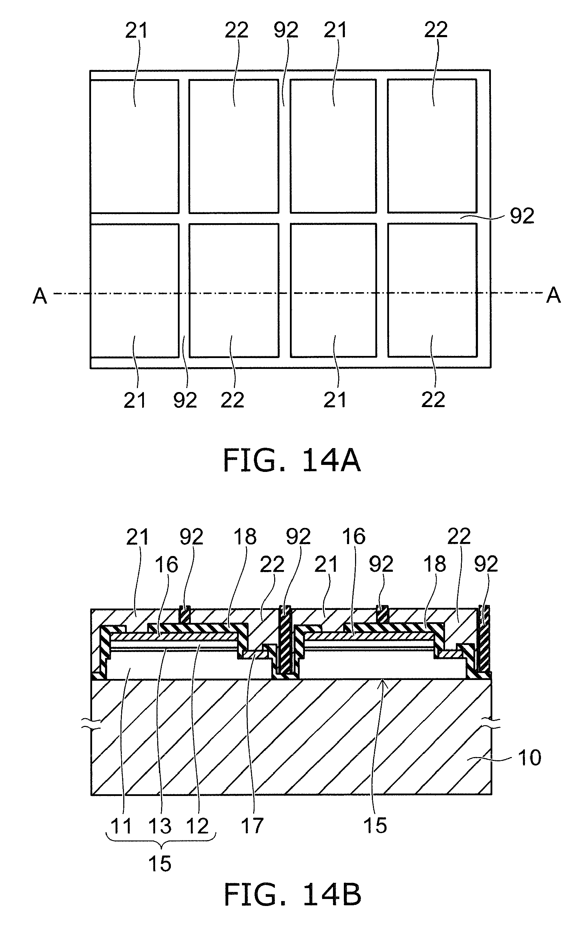

FIG. 14A shows one example of a planar layout of the p-side interconnect layer 21 and the n-side interconnect layer 22.

The p-side interconnect layer 21 and the n-side interconnect layer 22 occupy most of the region on the second face side and spread thereover.

Since the aluminum film 61 is provided underneath the p-side interconnect layer 21 and the n-side interconnect layer 22, the aluminum film (reflective film) 61 is formed spreading over most of the region on the second face side. According to this, the amount of a light directed to the phosphor layer 30 side can be increased.

A part of the p-side interconnect layer 21 and a part of the n-side interconnect layer 22 cover a side surface of the semiconductor layer 15 through the insulating film 18. That is, as shown in FIG. 13A, the foundation metal film 60 including the aluminum film 61 serving as the reflective film is formed also on the surface of the insulating film 18 covering the side surface of the semiconductor layer 15. Accordingly, a light (excitation light) which does not pass through the phosphor layer 30 can be prevented from leaking laterally, and thus, color breakup or color variations can be suppressed.

On the p-side interconnect layer 21, a p-side metal pillar (first metal pillar) 23 is provided. The p-side interconnect layer 21 and the p-side metal pillar 23 form a p-side interconnect unit (first interconnect unit) 41.

On the n-side interconnect layer 22, an n-side metal pillar (second metal pillar) 24 is provided. The n-side interconnect layer 22 and the n-side metal pillar 24 form an n-side interconnect unit (second interconnect unit) 43.

Between the p-side interconnect unit 41 and the n-side interconnect unit 43, a resin layer (composite resin) 56 is provided. The resin layer 56 is provided between the p-side metal pillar 23 and the n-side metal pillar 24 so as to be in contact with a side surface of the p-side metal pillar 23 and a side surface of the n-side metal pillar 24. That is, the resin layer 56 is filled between the p-side metal pillar 23 and the n-side metal pillar 24.

The resin layer 56 has a varistor characteristic. The resin layer 56 will be described in detail later.

The resin layer 56 is also provided between the p-side interconnect layer 21 and the n-side interconnect layer 22 on the insulating film 18. The resin layer 56 is provided on a periphery of the p-side metal pillar 23 and a periphery of the n-side metal pillar 24, and covers the side surface of the p-side metal pillar 23 and the side surface of the n-side metal pillar 24.

Further, the resin layer 56 is also provided in a peripheral region of the side surface 15c of the semiconductor layer 15, and covers the side surface 15c of the semiconductor layer 15 through either of the p-side interconnect layer 21 and the n-side interconnect layer 22 and through the insulating film 18.

An end portion (face) of the p-side metal pillar 23 on an opposite side to the p-side interconnect layer 21 is exposed from the resin layer 56, and functions as a p-side external terminal 23a which can be connected to an external circuit such as a mounting substrate. An end portion (face) of the n-side metal pillar 24 on an opposite side to the n-side interconnect layer 22 is exposed from the resin layer 56, and functions as an n-side external terminal 24a which can be connected to an external circuit such as a mounting substrate. The p-side external terminal 23a and the n-side external terminal 24a are bonded to a land pattern of the mounting substrate through, for example, a solder or a conductive bonding material.

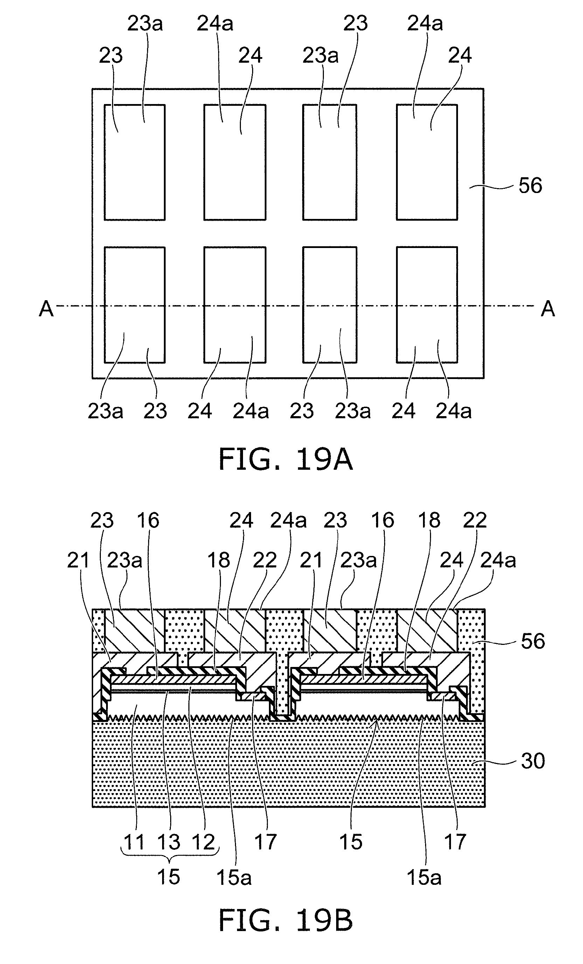

As shown in FIG. 19A, the p-side external terminal 23a and the n-side external terminal 24a are formed side by side spaced apart from each other in the same plane of the resin layer 56. An interval between the p-side external terminal 23a and the n-side external terminal 24a is larger than an interval between the p-side interconnect layer 21 and the n-side interconnect layer 22 on the insulating film 18.

The interval between the p-side external terminal 23a and the n-side external terminal 24a is set to be larger than the spreading area of the solder at the time of mounting. According to this, a short circuit between the p-side external terminal 23a and the n-side external terminal 24a through the solder can be prevented.

On the other hand, the interval between the p-side interconnect layer 21 and the n-side interconnect layer 22 can be narrowed to the limit on the process. Therefore, an area of the p-side interconnect layer 21, and a contact area between the p-side interconnect layer 21 and the p-side metal pillar 23 can be increased. According to this, the radiation of heat of the light emitting layer 13 can be enhanced.

An area of the n-side interconnect layer 22 spreading on the insulating film 18 can be made larger than an area of the n-side electrode 17. Then, an area of the n-side metal pillar 24 (an area of the n-side external terminal 24a) provided on the n-side interconnect layer 22 can be made larger than that of the n-side electrode 17. According to this, it becomes possible to decrease the area of the n-side electrode 17 while ensuring the area of the n-side external terminal 24a which is highly reliable and sufficient for mounting. That is, it becomes possible to enhance the light output by decreasing the area of the portion including no light emitting layer 13 and increasing the area of the portion including the light emitting layer 13 (light emitting region) in the semiconductor layer 15.

The first semiconductor layer 11 is electrically connected to the n-side metal pillar 24 through the n-side electrode 17 and the n-side interconnect layer 22. The second semiconductor layer 12 is electrically connected to the p-side metal pillar 23 through the p-side electrode 16 and the p-side interconnect layer 21.

A thickness of the p-side metal pillar 23 (a thickness in a direction connecting the p-side interconnect layer 21 to the p-side external terminal 23a) is thicker than a thickness of the p-side interconnect layer 21. A thickness of the n-side metal pillar 24 (a thickness in a direction connecting the n-side interconnect layer 22 to the n-side external terminal 24a) is thicker than a thickness of the n-side interconnect layer 22. A thickness of each of the p-side metal pillar 23, the n-side metal pillar 24, and the resin layer 56 is larger than that of the semiconductor layer 15.

An aspect ratio (a ratio of a thickness to a plane size) of each of the metal pillars 23 and 24 may be 1 or more, or may be less than 1. That is, the thickness of each of the metal pillars 23 and 24 may be larger or smaller than its plane size.

A thickness of the support 100 including the p-side interconnect layer 21, the n-side interconnect layer 22, the p-side metal pillar 23, the n-side metal pillar 24, and the resin layer 56 is thicker than a thickness of the LED chip including the semiconductor layer 15, the p-side electrode 16, and the n-side electrode 17.

The semiconductor layer 15 is formed on a substrate by an epitaxial growth method as described below. The substrate is removed after forming the support 100, and the semiconductor layer 15 does not include a substrate on the first face 15a side. The semiconductor layer 15 is not supported by a rigid and plate-shaped substrate, but is supported by the support 100, which is a composite body including the metal pillars 23 and 24 and the resin layer 56.

As a material of the p-side interconnect unit 41 and the n-side interconnect unit 43, for example, copper, gold, nickel, silver, or the like can be used. Among these, when copper is used, favorable thermal conductivity, high migration resistance, and adhesiveness to an insulating material can be enhanced.

The resin layer 56 reinforces the p-side metal pillar 23 and the n-side metal pillar 24. Further, it does not matter if a powder body having a light absorption property such as carbon black or a powder body having a light reflection property such as a metal or an alloy may be contained in a resin to serve as a base in the resin layer 56. In such a case, the resin layer 56 has a light shielding property or a reflection property with respect to an emitted light from the light emitting layer 13, and light leakage from a side surface and a mounting surface side of the support 100 can be suppressed.

By a thermal cycle when mounting the semiconductor light emitting device 1, stress derived from the solder or the like for bonding the p-side external terminal 23a and the n-side external terminal 24a to the land of the mounting substrate is applied to the semiconductor layer 15. The p-side metal pillar 23, the n-side metal pillar 24, and the resin layer 56 absorb and relax the stress. In particular, by using the resin layer 56 which is softer than the semiconductor layer 15 as a part of the support 100, a stress relaxation effect can be enhanced.

As described below, the substrate used for forming (growing) the semiconductor layer 15 is removed from the semiconductor layer 15. According to this, the height of the semiconductor light emitting device 1 can be decreased. Further, by removing the substrate, the first face 15a of the semiconductor layer 15 can be roughened, and thus, the light extraction efficiency can be improved.

For example, by wet-etching the first face 15a using an alkaline solution, fine irregularities are formed due to crystalline anisotropy. According to this, the total reflection components of the emitted light from the light emitting layer 13 are reduced, and a light to be extracted to the outside from the first face 15a can be increased.

Alternatively, fine irregularities may be formed on the first face 15a by etching using a mask formed by lithography.

After the substrate is removed, the phosphor layer 30 is formed on the first face 15a. Further, it is more preferred that an insulating film (not shown) is provided between the first face 15a and the phosphor layer 30. The insulating film enhances the adhesiveness between the semiconductor layer 15 and the phosphor layer 30, and is, for example, a silicon oxide film or a silicon nitride film.

The phosphor layer 30 has, for example, a structure in which a plurality of phosphors in the form of particles is dispersed in a transparent resin such as a silicone resin. The phosphors include a green phosphor, which is excited by the emitted light from the light emitting layer 13 and emits, for example, a green light, and a red phosphor, which is excited by the emitted light from the light emitting layer 13 and emits, for example, a red light. Alternatively, the phosphor layer 30 is not limited to a configuration including two types of phosphors (the green phosphor and the red phosphor), and may have a configuration including one type of phosphor (a yellow phosphor, which is excited by the emitted light from the light emitting layer 13 and emits, for example, a yellow light).

The phosphor layer 30 is formed also on the insulating film 18 in a peripheral region of the side surface 15c of the semiconductor layer 15. Accordingly, a plane size of the phosphor layer 30 is larger than that of the semiconductor layer 15.

The phosphor layer 30 is limited to an area on the first face 15a of the semiconductor layer 15 and on the peripheral region of the side surface 15c of the semiconductor layer 15, and is not formed to extend around the second face side of the semiconductor layer 15, the periphery of the metal pillars 23 and 24, and the side surface of the support 100. The side surface of the phosphor layer 30 and the side surface of the support 100 (the side surface of the resin layer 56) are aligned.

That is, the semiconductor light emitting device 1 of the embodiment is a very small semiconductor light emitting device having a chip-size package structure. Due to this, for example, when it is applied to a lighting fixture for illumination or the like, the degree of freedom of the design of the lighting fixture is increased.

Further, since there is no substrate between the first face 15a and the phosphor layer 30, color breakup or color variations caused by the leakage of a light with a strong color of a light from the light emitting layer 13 from a side surface of the substrate can be prevented.

Further, on the side of the mounting surface from which a light is not extracted to the outside, the phosphor layer 30 is not formed in vain, so that the cost can be reduced. Further, even if there is no substrate on the first face 15a side, heat of the light emitting layer 13 can be radiated to the mounting substrate side through the p-side interconnect layer 21 and the n-side interconnect layer 22 spreading on the second face side, and thus, a heat dissipation property is excellent although the size is small.

In a common flip-chip assembly, after an LED chip is mounted on a mounting substrate through bumps, a phosphor layer is formed so as to cover the entire chip. Alternatively, a resin is underfilled between bumps.

On the other hand, according to the embodiment, in a state before mounting, the resin layer 56 which is different from the phosphor layer 30 is provided on the periphery of the p-side metal pillar 23 and the periphery of the n-side metal pillar 24, so that a property suitable for relaxing stress can be imparted on the mounting surface side. In addition, since the resin layer 56 has already been provided on the mounting surface side, underfill after mounting is not needed.

On the first face 15a side, a layer which is designed for prioritizing light extraction efficiency, color conversion efficiency, light distribution characteristics, etc. is provided, and on the mounting surface side, a layer which prioritizes stress relaxation at the time of mounting, and characteristics as the support to be substituted for the substrate is provided.

A light emitted from the light emitting layer 13 to the first face 15a side is incident on the phosphor layer 30, and a part of the light excites the phosphor, and for example, a white light is obtained as a mixed light of the light from the light emitting layer 13 and the light from the phosphor.

Here, if there is a substrate on the first face 15a, the light is not incident on the phosphor layer 30, and leaks to the outside from a side surface of the substrate. That is, a light with a strong color of the light from the light emitting layer 13 leaks from a side surface of the substrate, and color breakup or color variations such as a phenomenon in which a blue light ring is seen on an outer peripheral side when an object is lit up from the phosphor layer 30 side can be caused.

On the other hand, according to the invention, there is no substrate between the first face 15a and the phosphor layer 30, and therefore, color breakup or color variations due to leakage of a light with a strong color of the light from the light emitting layer 13 from a side surface of the substrate can be prevented.

Further, according to the embodiment, the above-described reflective metal (aluminum film 61) is provided on the side surface 15c of the semiconductor layer 15, and therefore, a light directed to the side surface 15c of the semiconductor layer 15 from the light emitting layer 13 does not leak to the outside. According to this, in cooperation with the feature that there is no substrate on the first face 15a side, color breakup or color variations due to leakage of a light from a side surface side of the semiconductor light emitting device 1 can be prevented.

Next, the resin layer (composite resin) 56 will be described.

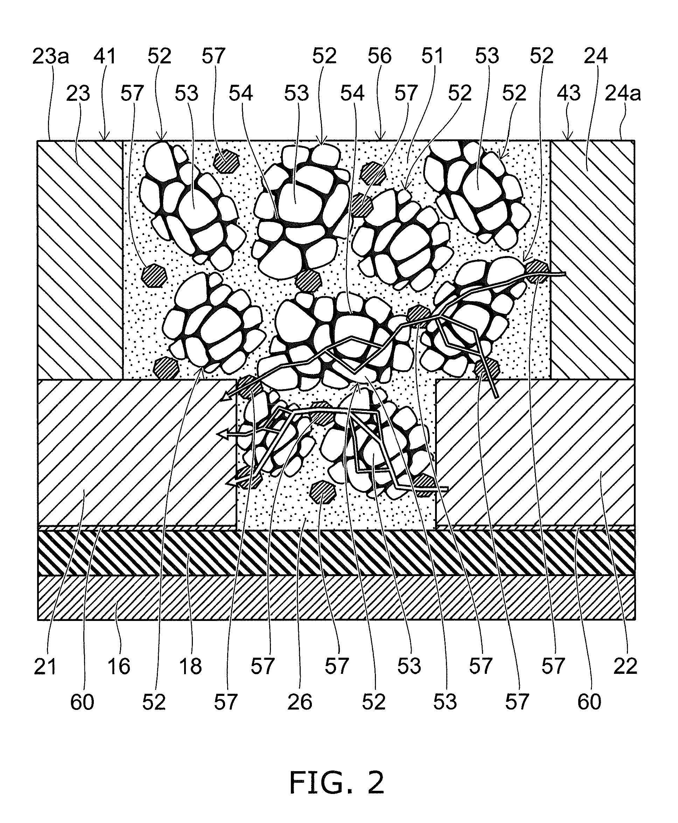

FIG. 2 is a schematic enlarged cross-sectional view of a portion surrounded by a two-dot chain line in FIG. 1.

The resin layer 56 is a composite resin including an insulating resin component 51 and a plurality of first powder bodies 52, the plurality of first powder bodies 52 is dispersed in the resin component 51. The plurality of first powder bodies 52 is a polycrystalline powder body including a plurality of primary particles 53 bound via a grain boundary 54.

The primary particle 53 contains, for example, zinc oxide as a main component and has a semiconductor of a wurtzite crystal structure. At the grain boundary 54, a component different from the main component of the plurality of primary particles 53 is segregated. A component that is different from the main component of the primary particle 53 exists in a higher concentration at the grain boundary 54 than in the primary particle 53 interior. For example, at the grain boundary 54, at least either of bismuth oxide and praseodymium oxide is segregated at a higher concentration than in the inside of the primary particle 53.

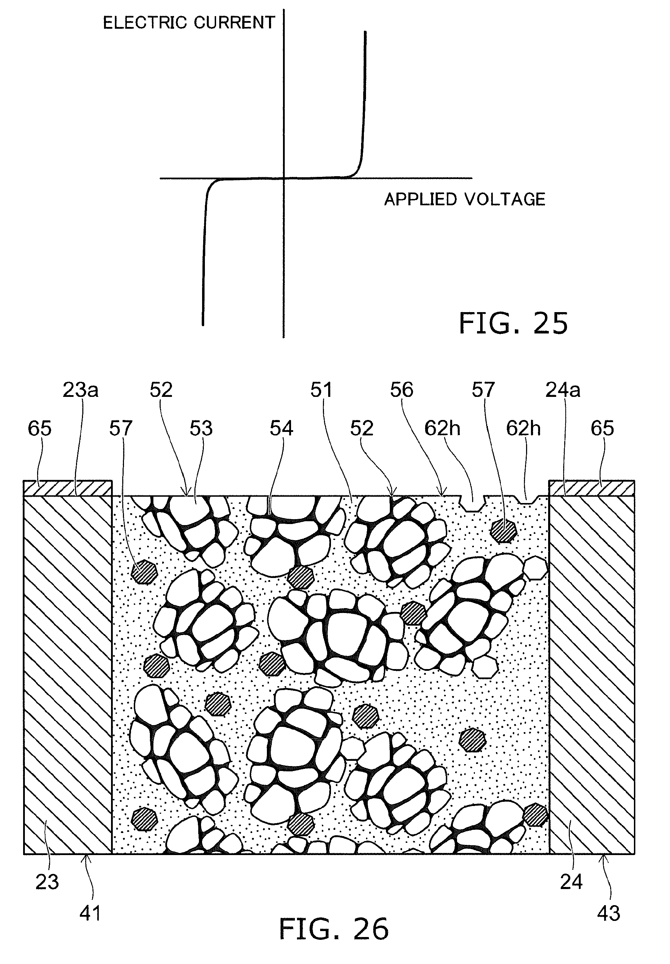

As shown in FIG. 25, the first powder body 52 has a nonlinear current-voltage characteristic such that a resistance decreases as an applied voltage increases, that is, has a varistor characteristic.

Further, to the first powder body 52, at least any of cobalt, manganese, chromium, antimony, strontium, lead, barium, and magnesium is added. These additives can produce a steep resistance change.

Further, in the composite resin 56 of the embodiment, in addition to the above-described first powder bodies 52, the plurality of second powder bodies 57 having electrical conductivity is dispersed in the resin component 51. The second powder body 57 is a particle having a size smaller than that of the first powder body 52. A work function of the plurality of second powder bodies 57 is not more than that of the plurality of primary particles 53. Therefore, an ohmic contact can be formed between the primary particle 53 of the first powder body 52 and the second powder body 57. According to this, when a surge of an electronic device using the first powder body 52 and the second powder body 57 is discharged, a low-resistance bypass path is obtained.

Incidentally, the term "size of the powder body (particle)" as used herein refers to an average particle diameter of the plurality of powder bodies (particles), or a peak particle diameter or a maximum particle diameter in a particle size distribution.

The second powder body 57 contains, for example, at least any of tungsten, ruthenium, rhenium, molybdenum, and chromium. By using these materials, oxidation hardly proceeds inside the second powder body 57, and therefore, the second powder body 57 has stable electrical conductivity. Further, by using at least any of tungsten, ruthenium, rhenium, molybdenum, and chromium, the second powder body 57 is less likely to be corroded, and thus, the reliability of the resin layer 56 and an electronic device using the resin layer 56 can be enhanced.

Further, the second powder body 57 using at least any of tungsten, ruthenium, rhenium, molybdenum, and chromium has a relatively high melting point. According to this, when a surge is input, the second powder body 57 is hardly melted and scattered therearound. Due to this, it becomes possible to prevent the occurrence of a leakage defect of an electronic device using the second powder body 57.

The second powder body 57 can use, for example, at least either of ITO (indium tin oxide) and IGZO (InGaZnOx) other than the above-described materials. When using these oxides, an increase in resistance accompanying oxidation of a surface of the second powder body 57 is less likely to occur, and thus, the second powder body 57 has stable electrical conductivity. Due to this, the reliability of an electronic device using the second powder body 57 can be enhanced. Further, the second powder body 57 using the above oxide is less likely to be corroded, and therefore, the reliability is high.

Further, the second powder body 57 using the above oxide has a relatively high melting point. According to this, when a surge is input, the second powder body 57 is hardly melted and scattered therearound. Due to this, it becomes possible to prevent the occurrence of a leakage defect of an electronic device using the second powder body 57.

The second powder body 57 can use at least any of tantalum, titanium, niobium, manganese, aluminum, and zirconium other than the above-described materials. On a surface of the second powder body 57 using these materials, an oxide coating film (passive film) which resists the corrosive action is formed. According to this, the second powder body 57 has stable electrical conductivity. Due to this, the reliability of an electronic device using the second powder body 57 can be enhanced.

The second powder body 57 can use, for example, hafnium other than the above-described materials. The second powder body 57 using hafnium is chemically stabilized. Due to this, the reliability of an electronic device using the second powder body 57 can be enhanced.

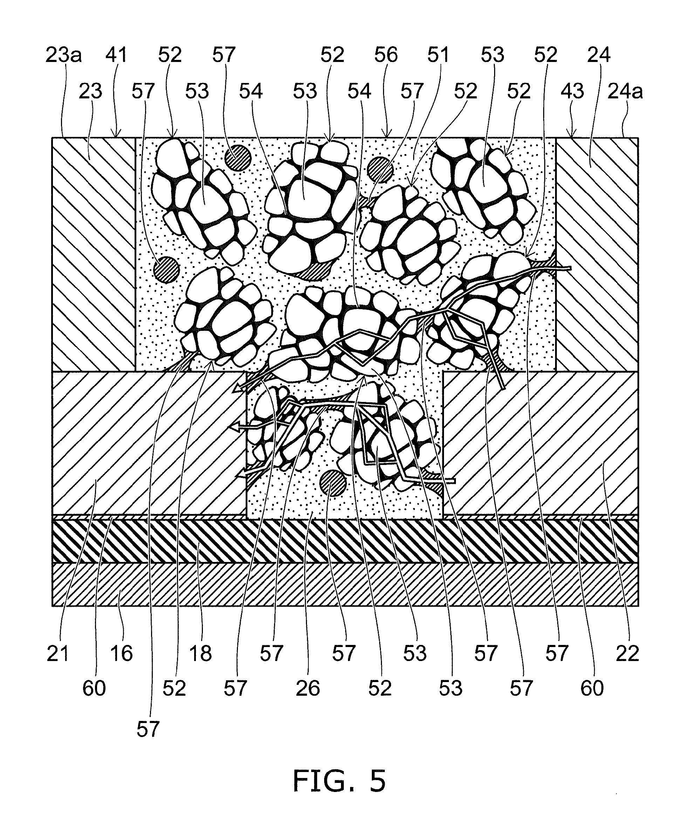

Further, by using, for example, a metal having a melting point lower than a heat-resistant temperature of the resin component 51 (for example, at least any of tin, bismuth, lead, and indium) as the second powder body 57 other than the above-described materials, the second powder body 57 can be fusion-bonded to the surface of the first powder body 52 or the surface of the interconnect unit 41 or 43 as shown in FIG. 5 by heating when forming the resin layer 56, or in a process before or after forming the resin layer 56. According to this, a contact resistance between the second powder body 57 and the first powder body 52, or a contact resistance between the second powder body 57 and the interconnect unit 41 or 43 can be decreased.

The second powder body 57 can use, for example, silver other than the above-described materials. The second powder body 57 using silver has a high reflection property. According to this, the light output of an electronic device using the second powder body 57 can be improved.

The second powder body can use, for example, at least any of iron, silicon, antimony, boron, gallium, vanadium, zinc, magnesium, thorium, neodymium, and yttrium other than the above-described materials. According to this, when a surge of an electronic device using the second powder body 57 is discharged, a lower-resistance bypass path is obtained.

The second powder body 57 can use, for example, a metal which is less likely to be oxidized such as gold or platinum other than the above-described materials. Further, the second powder body 57 can use an inexpensive metal such as copper or nickel. Alternatively, the second powder body 57 can use an alloy metal which is less likely to be oxidized and has a property of having a low thermal expansion coefficient such as 42 alloy, Invar, or Kovar.

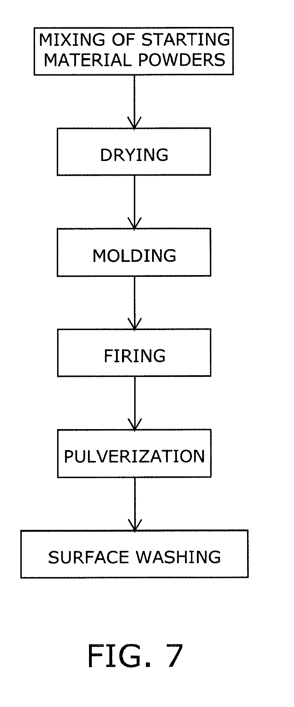

FIG. 7 is a flow chart showing a manufacturing method for the first powder bodies 52.

First, starting material powders of zinc oxide, bismuth oxide, cobalt oxide, manganese oxide, antimony oxide, a binder (an organic substance), etc. are mixed.

Then, a mixture of these materials is dried, molded, and fired, followed by pulverization, whereby the plurality of first powder bodies 52 is obtained.

Thereafter, as needed, the surfaces of the first powder bodies 52 are washed. By this washing, a segregated component which is the same component segregated at the grain boundary 54 and covers the surfaces of the primary particles 53 is removed, whereby the surfaces of the primary particles 53 can be exposed.

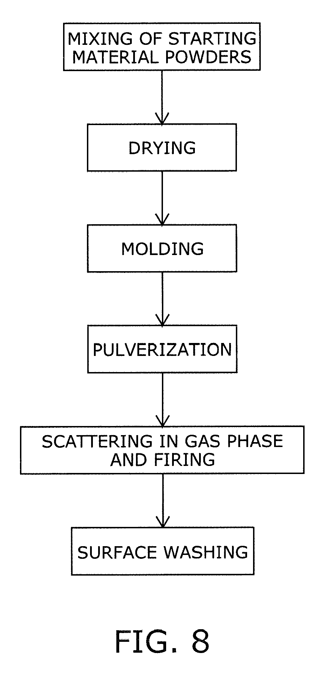

FIG. 8 is a flow chart showing another manufacturing method for the first powder bodies 52.

First, starting material powders of zinc oxide, bismuth oxide, cobalt oxide, manganese oxide, antimony oxide, a binder (an organic substance), etc. are mixed.

Then, a mixture of these materials is dried and molded, followed by pulverization, whereby the plurality of first powder bodies 52 is obtained.

Thereafter, the plurality of powder bodies is scattered in a gas phase, and fired. Then, as needed, the surfaces of the first powder bodies 52 are washed.

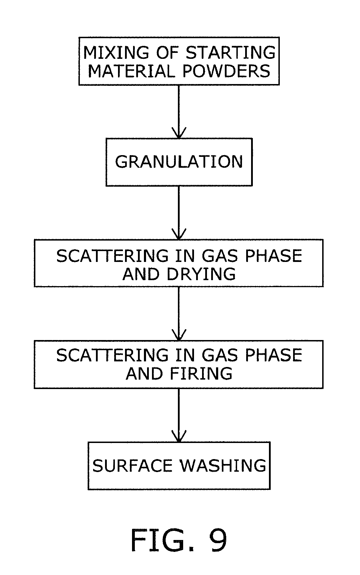

FIG. 9 is a flow chart showing still another manufacturing method for the first powder bodies 52.

First, starting material powders of zinc oxide, bismuth oxide, cobalt oxide, manganese oxide, antimony oxide, a binder (an organic substance), etc. are mixed.

Then, a mixture of these materials is granulated, whereby plurality of first powder bodies 52 is obtained. As a granulation method, the mixture may be extruded by an extruder, followed by cutting, or a spray-drying method may be used.

Thereafter, the plurality of powder bodies is scattered in a gas phase, and dried and fired. Then, as needed, the surfaces of the first powder bodies 52 are washed.

For example, bismuth oxide is hardly solid-dissolved in zinc oxide, and also has a low melting point, and therefore is segregated at the grain boundary 54 as a sintering agent. In the vicinity of the grain boundary 54 at which bismuth oxide is segregated, a high-energy barrier which is considered to be a Schottky-barrier is formed, and therefore, at the grain boundary 54, a thin high-resistance layer is formed. Incidentally, hereinafter, this energy barrier is referred to as "Schottky-barrier" for the sake of convenience.

The exhibition of a varistor behavior is considered to be caused by the Schottky-barrier formed in the vicinity of the grain boundary 54. That is, when a high voltage such as a surge voltage is applied to the grain boundary 54, a tunneling current begins to flow through the Schottky-barrier, and the resistance rapidly decreases.

That is, the first powder body 52 is an insulating body at a rated voltage or less, but its resistance decreases when a high voltage such as a surge is applied, and a bypass path (short-circuit path) for discharging the surge is formed in the first powder body 52. In FIGS. 2 to 5, a bypass path for a surge is schematically indicated by the outline arrow. A voltage at which the resistance rapidly decreases (breakdown voltage) is proportional to the number of serial connections of the grain boundaries 5 present in a surge bypass path.

Incidentally, it does not matter if praseodymium oxide is used in place of bismuth oxide. It is known that also in this case, a similar varistor characteristic is obtained. It is also known that, in the case of using praseodymium oxide, the size of the primary particle is decreased as compared with the case of using bismuth oxide. Accordingly, in the case where a finer structure is desired to be obtained, that is, a distance between the p-side interconnect unit and the n-side interconnect unit is desired to be decreased, it is more preferred to use praseodymium oxide. Incidentally, it is not necessary to limit a component to be segregated in the vicinity of the grain boundary 54 at a high concentration to bismuth oxide and praseodymium oxide. The point is that as long as the composition exhibits a varistor characteristic through the grain boundary of the primary particles, a similar effect can be expected. Further, the starting material powder of the first powder bodies 52 is not necessarily an oxide, and for example, bismuth, praseodymium, or the like may be used as the starting material powder and oxidized during sintering.

A surface of the p-side interconnect unit 41 and a surface of the n-side interconnect unit 43 are connected to the first powder body 52 through the second powder body 57 having electrical conductivity. Due to this, a resistance between the p-side interconnect unit 41 and the first powder body 52, and a resistance between the n-side interconnect unit 43 and the first powder body 52 can be decreased, and a low-resistance bypass path is obtained when a surge is discharged.

Further, the plurality of first powder bodies 52 is dispersed at such a high density, a distance between adjacent first powder bodies 52 is not more than the size of the second powder body 57. Due to this, the second powder body 57 is interposed between the adjacent first powder bodies 52 in contact with the first powder bodies 52 so that a resistance between the adjacent first powder bodies 52 can also be decreased.

The composite resin 56 is, for example, cured after formed in a state of a liquid containing a solvent. Therefore, if the composite resin 56 is configured to be shrunk when the solvent is evaporated or at the time of curing, the second powder body 57 more easily comes in contact with the first powder body 52 or the interconnect unit 41 or 43.

Further, in a state where a volume of the resin component 51 is large before the solvent is evaporated or the resin is cured and shrunk, the viscosity of the resin can be decreased, and therefore, the resin layer (composite resin) 56 is easily formed.

According to the embodiment, between the p-side external terminal 23a and the n-side external terminal 24a, which can be exposed to the outside in a state before mounting, the semiconductor layer 15 and the first powder body 52 are connected in parallel to each other, and the first powder body 52 functions as a protective element which protects the semiconductor layer 15 from a surge voltage. A surge current can flow between the p-side external terminal 23a and the n-side external terminal 24a through the first powder body 52 without passing through the semiconductor layer 15.

At the time of a normal operation in which a power supply voltage of a rated voltage or less is applied between the p-side external terminal 23a and the n-side external terminal 24a, the first powder body 52 is in a high-resistance state due to a Schottky-barrier in the vicinity of the grain boundary 54, and therefore, a short circuit between the p-side interconnect unit 41 and the n-side interconnect unit 43 does not occur through the first powder body 52.

Further, the size of the primary particle 53 is smaller than the minimum distance between the p-side interconnect layer 21 and the n-side interconnect layer 22 on the insulating film 18. Due to this, the p-side interconnect layer 21 and the n-side interconnect layer 22 are not bridged to each other only with one primary particle 53.

As shown in FIG. 2, for example, the first powder body 52 is provided between the p-side interconnect layer 21 and the n-side interconnect layer 22. At this time, a contact can be easily obtained through both ends of the first powder body 52, and therefore, a surge current flows through the entire first powder body 52. In such a case, in particular, in a central portion of the first powder body 52, a current density is decreased, and therefore, a surge breakdown does not easily occur at a grain boundary present in the portion.

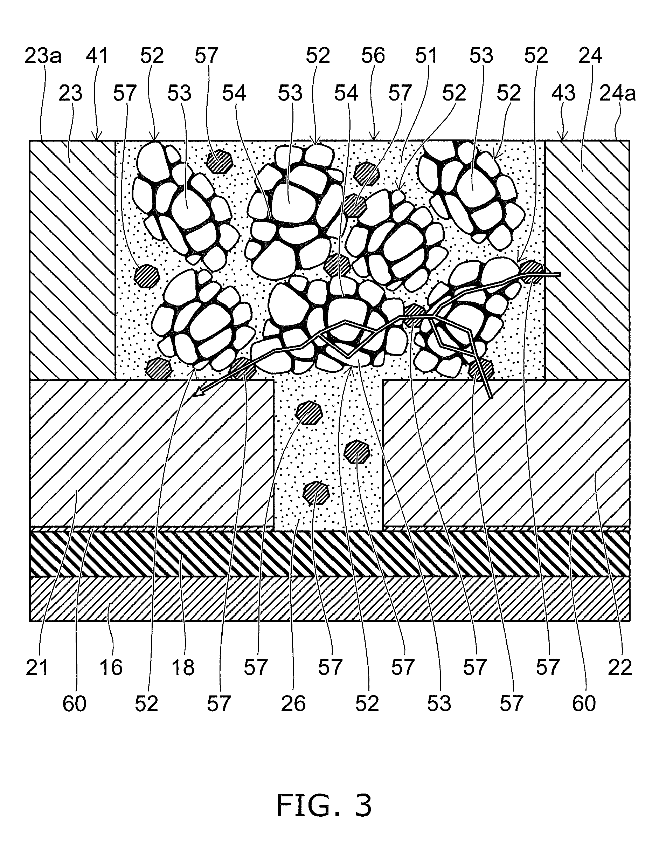

As shown in FIG. 3, for example, the first powder body 52 is not provided between the p-side interconnect layer 21 and the n-side interconnect layer 22. When the interconnect layers are formed such that the distance therebetween is smaller, a structure in which the first powder body 52 is not provided in a space therebetween can be easily obtained. In this manner, by forming the interconnect layers such that the distance therebetween is smaller, the interconnect layers can be provided on faces facing the light emitting layer, and thus, a structure in which heat generated from the light emitting layer or the like is easily radiated is obtained.

In a bypass path between the p-side interconnect layer 21 and the n-side interconnect layer 22 bridged to each other with the polycrystalline first powder body 52 in which the plurality of primary particles 53 is connected to one another through the grain boundary 54, one or more grain boundaries 54 having a Schottky-barrier characteristic are surely present. Therefore, at the time of a normal operation, a short circuit does not occur between the p-side interconnect layer 21 and the n-side interconnect layer 22.

Further, the size of the second powder body 57 is smaller than the minimum distance between the p-side interconnect layer 21 and the n-side interconnect layer 22, and therefore, a short circuit, in which the second powder bodies 57 are bridged to each other between the p-side interconnect layer 21 and the n-side interconnect layer 22, does not occur.

Further, a blending ratio of the plurality of second powder bodies 57 to the resin component 51 is set to be low to such an extent that the second powder bodies 57 are not bridged to each other, and therefore, a short-circuit path is not formed only by the second powder bodies 57.

However, as described above, the size of the second powder body 57 is smaller than the minimum distance between the p-side interconnect layer 21 and the n-side interconnect layer 22, and therefore, the second powder bodies 57 are hardly bridged to each other as long as the blending ratio of the plurality of second powder bodies 57 to the resin component 51 is set to be extremely high. On the other hand, as the blending ratio of the plurality of second powder bodies 57 to the resin component 51 is higher, the number of the formed surge bypass paths is increased, and therefore, the blending ratio is desired to be made as high as possible. In such a case, the effect of the property of the second powder body 57 itself becomes larger with respect to the property of the composite resin 56. In order to prevent the warpage of a device or a wafer, it is necessary that the thermal expansion coefficient of the composite resin 56 is small, and therefore, in such a case, it is preferred that as the second powder body 57, a material having a low thermal expansion coefficient such as 42 alloy, Invar, or Kovar is used.

The thermal expansion coefficient of the second powder body 57 is preferably, for example, not higher than 5.5 ppm, which is the thermal expansion coefficient of gallium nitride (in an a-axis direction). In this case, by the addition of the second powder body 57, the thermal expansion coefficient of the entire composite resin 56 further approaches that of gallium nitride forming a light emitting element.

For example, 42 alloy has a thermal expansion coefficient of approximately 4.5 to 6.5 ppm, and Kovar has a thermal expansion coefficient of approximately 5 ppm.

Further, the thermal expansion coefficient of the second powder body 57 is more preferably not higher than 3.9 ppm, which is the thermal expansion coefficient of zinc oxide serving as the first powder body 52 (in a c-axis direction). In this case, by the addition of the second powder body 57, the thermal expansion coefficient of the entire composite resin 56 can be made further lower than in the case of a combination of only the first powder bodies 52 and the resin component 51.

The thermal expansion coefficient of Invar composed of 65% iron and 35% nickel is 1.2 ppm, and the thermal expansion coefficient of Super Invar composed of 64% iron, 32% nickel, and 4% cobalt, Stainless Invar obtained by adding chromium, or the like is 0 ppm.

An epoxy resin which is generally used in the resin component 51 has a high thermal expansion coefficient of approximately 60 ppm, and therefore, even if zinc oxide having a thermal expansion coefficient of 3.9 ppm is used in the first powder body 52, it is difficult to decrease the thermal expansion coefficient of the entire composite resin 56 to 5.5 ppm, which is the thermal expansion coefficient of gallium nitride. Here, by using the second powder body 57 having a low thermal expansion coefficient, the thermal expansion coefficient of the entire composite resin 56 can be made to further approach 5.5 ppm, which is the thermal expansion coefficient of gallium nitride.

Further, in the case where the thermal expansion coefficient of the second powder body 57 is lower than 3.9 ppm, which is the thermal expansion coefficient of zinc oxide, for example, even if the first powder body 52 having a small particle diameter coexists in the vicinity of the second powder body 57, a conductive path due to the second powder body 57 is easily formed. This is because the second powder body 57 is relatively larger than the first powder body 52 having a small particle diameter due to a decrease in the temperature to normal temperature after thermal curing of the composite resin 56.

Further, according to the first embodiment, the composite resin 56 having a varistor characteristic is provided as a sealing resin in the semiconductor light emitting device 1. Therefore, an antistatic circuit to be externally connected to the semiconductor light emitting device 1 is not needed. That is, it is not necessary to mount a Zener diode as an ESD protective element for LED. Therefore, according to the first embodiment, the semiconductor light emitting device 1 having excellent electrostatic resistance can be provided without hindering miniaturization of the semiconductor light emitting device 1 having a chip-size package structure.

Further, in the resin component 51 of the composite resin 56, a powder body 26 having a light shielding property such as a powder body having a light absorption property of carbon black or the like, or a powder body having a light reflection property of a metal, an alloy, or the like, may be contained. That is, the composite resin 56 has a light shielding property against an emitted light from the light emitting layer 13. According to this, the first powder body 52 can be protected from the emitted light from the light emitting layer 13, and thus, a malfunction or the like of the first powder body 52 can be prevented. Incidentally, the term "malfunction" as used herein refers to, for example, an event in which an electron is excited inside the powder body 52 by an incident light so that the current-voltage characteristic is changed, or a light having a longer wavelength is emitted.

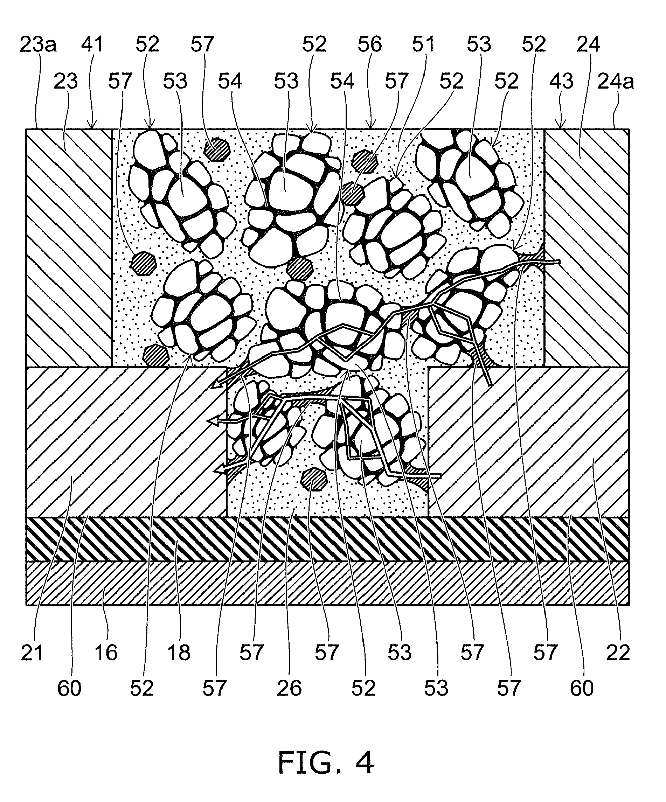

Further, after the composite resin 56 is formed, by heat generated by a surge applied between the p-side interconnect unit 41 and the n-side interconnect unit 43, the second powder body 57 present in a surge bypass path is melted, and as shown in FIG. 4, the second powder body 57 can be fusion-bonded to the surface of the first powder body 52 or the surface of the interconnect unit 41 or 43.

That is, the second powder body 57 is melted and comes in contact with the surface of the first powder body 52 or the surface of the interconnect unit 41 or 43 in a wet-spreading form on the surface of the first powder body 52 or the surface of the interconnect unit 41 or 43. Due to this, a contact resistance between the second powder body 57 and the first powder body 52, or a contact resistance between the second powder body 57 and the interconnect unit 41 or 43 can be decreased.

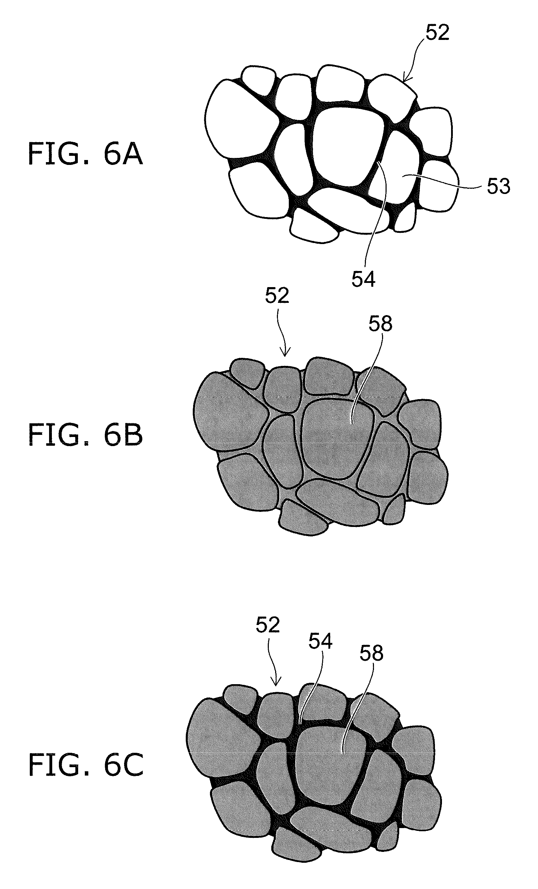

Further, as shown in FIG. 6C, in the case where a thin metal film 58 is formed discontinuously on the surface of the first powder body 52, while decreasing a contact resistance between the first powder body 52 and the second powder body 57, a defect in which the metal film 58 forms a short-circuit path on the surface of the first powder body 52 does not occur.

FIGS. 6A to 6C are schematic views showing a method for forming the discontinuous metal film 58 on the surface of the first powder body 52.

For example, by the above-described methods shown in FIGS. 7, 8, and 9, the first powder body 52 with the primary particles 53 exposed on the surface thereof can be manufactured. On the surface of the first powder body 52, the metal film 58 is formed by, for example, a sputtering method or the like. At this time point, as shown in FIG. 6B, the metal film 58 is formed continuously on the surface of the primary particles 53 and the surface of the grain boundary 54.

Subsequently, in a state where the first powder body 52 is scattered in a gas phase in an inert atmosphere, heating is performed at a temperature not lower than the melting point of bismuth oxide or praseodymium oxide segregated at the grain boundary 54, whereby the metal film 58 formed on the surface of the grain boundary 54 is melted.

By doing this, as shown in FIG. 6C, the metal film 58 is left discontinuously only on the surfaces of the primary particles 53.

Here, as the discontinuous metal film 58, a metal having a reflection property with respect to a light emitted from the light emitting layer 13 is used, a light reflection property can be imparted to the composite resin. As such a light reflective metal, for example, silver, aluminum, platinum, or the like can be used.

By imparting a light reflection property to the composite resin, the first powder body 52 can be protected from an emitted light from the light emitting layer 13. According to this, a malfunction (for example, due to the excitation of an electron inside the powder body 52 by an incident light, a current-voltage characteristic is changed, or a light having a long wavelength is emitted) of the first powder body 52 or the like can be suppressed.

For example, when a powder having a light reflection property such as titanium oxide or silver is dispersed in the resin component, a light reflection property can be imparted to the composite resin. However, in the case of the device of the above-described embodiment, if titanium oxide is dispersed to such an extent that the composite resin has a sufficient reflection property, the composite resin becomes an insulating material, and alternatively, if silver is dispersed to such an extent that the composite resin has a sufficient reflection property, the composite resin becomes a conductive material, and therefore, a varistor characteristic which is the feature of the embodiment is deteriorated.

However, by forming the discontinuous metal film 58 on the powder body 52 itself as described above, the composite resin having a light reflection property can be formed without deteriorating the varistor characteristic.

As a method for forming the discontinuous metal film 58, it is also possible to use electroless plating. Since the primary particle (containing, for example, zinc oxide as a main component and having a semiconductor of a wurtzite crystal structure) 53 is an n-type semiconductor, an electron is present in a conduction band. On the other hand, since an energy barrier is formed at the grain boundary 54 and in the vicinity thereof, the state is such that an electron is not present in a conduction band. By transferring the electron present in the primary particle 53 to a metal ion in a plating solution to effect reduction, a film can be grown as the metal film 58. At this time, an electron is not present at the grain boundary 54 and in the vicinity thereof, and therefore, the discontinuous metal film 58 covering only the surfaces of the primary particles 53 can be formed.

As the metal capable of forming the metal film 58 by electroless plating, for example, silver, gold, nickel, or the like can be used. Among these, silver having a high reflectance is desired.

Further, according to need, by irradiating the primary particle 53 with a light, it is possible to enhance the plating efficiency by exciting an electron in a conduction band. Further, in order to efficiently transfer an electron in a conduction band to a metal ion in a plating solution, it is also possible to add an additive such as a reducing agent to the plating solution. As the additive, for example, EDTA (ethylenediaminetetraacetic acid) or the like can be used.

Incidentally, it is also possible to form a very thin transparent insulating film after forming the discontinuous metal film 58. For the formation of such an insulating film, a method such as sputtering can be used. By forming the insulating film sufficiently thin, or by using a material having a lot of defects or a hygroscopic material, dielectric breakdown occurs by applying an electric field to the composite resin, so that a necessary surge current path can be ensured. Since an electric current does not flow other than the surge current path, the insulating film still remains, and due to this, a decrease in reflectance by corrosion, sulfurization, or the like of the metal film 58 is less likely to occur.

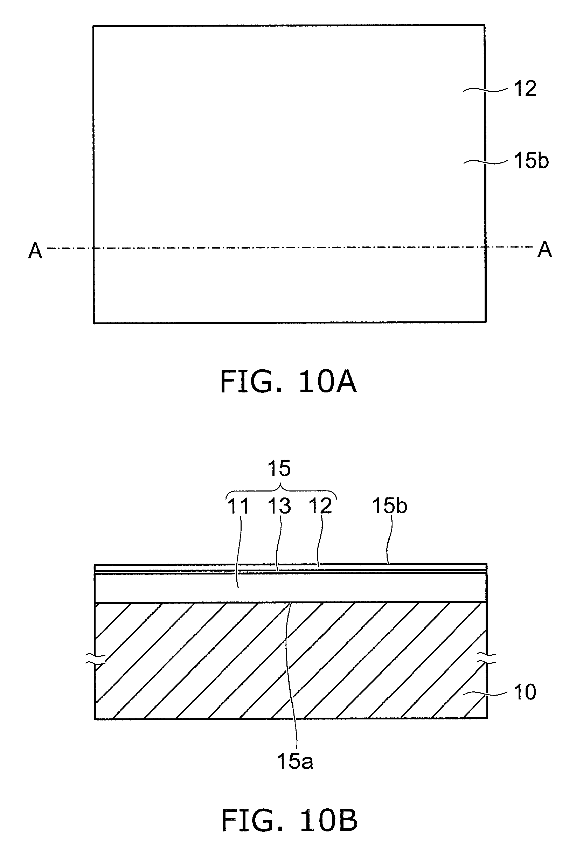

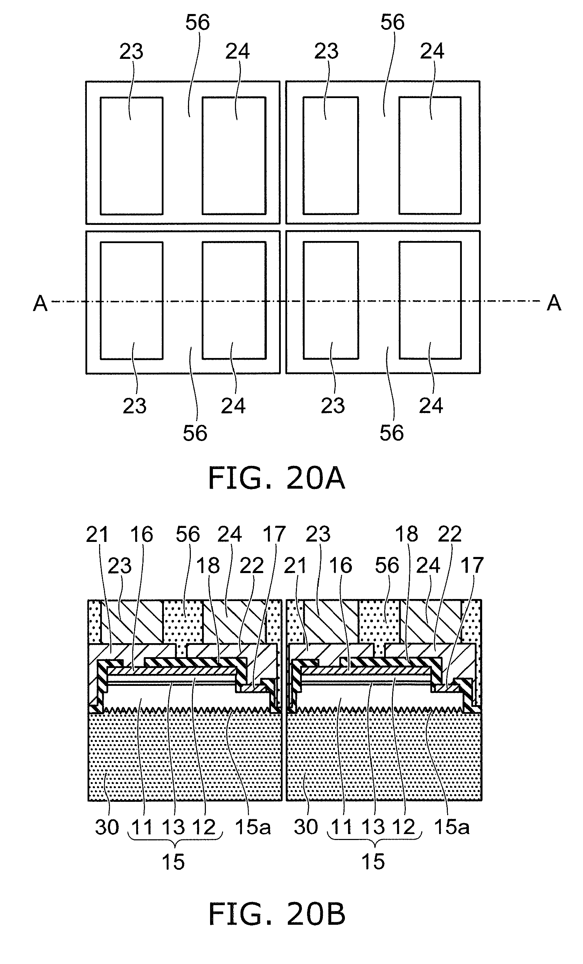

Next, with reference to FIGS. 10A to 20B, a manufacturing method for the semiconductor light emitting device 1 of the first embodiment will be described.

FIGS. 10B, 11B, 12B, 14B, 15B, 16B, 17B, 19B, and 20B, correspond to cross sections taken along the line A-A of FIGS. 10A, 11A, 12A, 14A, 15A, 16A, 17A, 19A, and 20A, respectively.

That is, FIGS. 10A, 11A, 12A, 14A, 15A, 16A, 17A, 19A, and 20A are top views of FIGS. 10B, 11B, 12B, 14B, 15B, 16B, 17B, 19B, and 20B, respectively. These top views each show a partial region of a circular wafer.

FIG. 10B is a cross-sectional view showing the semiconductor layer 15 formed on a major surface of the substrate 10. For example, by an MOCVD (metal organic chemical vapor deposition) method, the first semiconductor layer 11, the light emitting layer 13, and the second semiconductor layer 12 are epitaxially grown in this order on the major surface of the substrate 10.

In the semiconductor layer 15, a face on the substrate 10 side is the first face 15a, and a face on the opposite side to the substrate 10 is the second face 15b.

The substrate 10 is, for example, a silicon substrate. Alternatively, the substrate 10 may be a sapphire substrate or a SiC substrate. The semiconductor layer 15 is, for example, a nitride semiconductor layer containing gallium nitride (GaN).

The first semiconductor layer 11 has, for example, a buffer layer provided on the major surface of the substrate 10 and an n-type GaN layer provided on the buffer layer. The second semiconductor layer 12 has, for example, a p-type AlGaN layer provided on the light emitting layer 13 and a p-type GaN layer provided thereon. The light emitting layer 13 has, for example, an MQW (Multiple Quantum Well) structure.

The second semiconductor layer 12 and the light emitting layer 13 are selectively removed by, for example, an RIE (Reactive Ion Etching) method as shown in FIG. 11B. By selective etching of the second semiconductor layer 12 and the light emitting layer 13, the first semiconductor layer 11 is exposed.

Further, as shown in FIGS. 11A and 11B, the first semiconductor layer 11 is selectively removed, whereby a groove 91 is formed. On the major surface of the substrate 10, the semiconductor layer 15 is divided into a plurality of regions by the groove 91. The groove 91 passes through the semiconductor layer 15 and reaches the substrate 10. There is also a case where the major surface of the substrate 10 is also etched slightly depending on the etching conditions, and a bottom surface of the groove 91 is retreated downward from a boundary surface between the substrate 10 and the semiconductor layer 15. Incidentally, the groove 91 may be formed after forming the p-side electrode 16 and the n-side electrode 17.

On a surface of the second semiconductor layer 12, the p-side electrode 16 is formed. On a surface of the first semiconductor layer 11 in a region where the second semiconductor layer 12 and the light emitting layer 13 are selectively removed, the n-side electrode 17 is formed.

The p-side electrode 16 and the n-side electrode 17 are formed by, for example, a sputtering method, a vapor deposition method, or the like. It does not matter which of the p-side electrode 16 and the n-side electrode 17 is formed first, and also, the p-side electrode 16 and the n-side electrode 17 may be formed simultaneously with the same material.

The p-side electrode 16 formed in a region where the light emitting layer 13 is stacked includes a reflective film which reflects an emitted light from the light emitting layer 13. For example, the p-side electrode 16 contains silver, a silver alloy, aluminum, an aluminum alloy, or the like. Further, in order to prevent sulfurization or oxidation of the reflective film, the p-side electrode 16 includes a metal protective film (barrier metal).

Subsequently, as shown in FIGS. 12A and 12B, the insulating film 18 is formed so as to cover the structure body provided on the substrate 10. The insulating film 18 covers the second face of the semiconductor layer 15, the p-side electrode 16, and the n-side electrode 17. Further, the insulating film 18 covers the side surface 15c continuous with the first face 15a of the semiconductor layer 15. Further, the insulating film 18 is also formed on the surface of the substrate 10 on the bottom surface of the groove 91.

The insulating film 18 is, for example, a silicon oxide film or a silicon nitride film formed by a CVD (Chemical Vapor Deposition) method. In the insulating film 18, the first opening 18a and the second opening 18b are formed by, for example, wet etching using a resist mask. The first opening 18a reaches the p-side electrode 16, and the second opening 18b reaches the n-side electrode 17.

Subsequently, as shown in FIG. 13A, the foundation metal film 60 is formed conformally on the surface of the insulating film 18, the inner wall (the side wall and the bottom surface) of the first opening 18a, and the inner wall (the side wall and the bottom surface) of the second opening 18b.

The foundation metal film 60 has the aluminum film 61, the titanium film 62, and the copper film 63 as described above with reference to FIG. 13B. The foundation metal film 60 is formed by, for example, a sputtering method.

In the diagrams of the succeeding processes, the illustration of the foundation metal film 60 is omitted.

On the foundation metal film 60, as shown in FIGS. 14A and 14B, a resist mask 92 is selectively formed. Then, by an electrolytic copper plating method using the copper film 63 of the foundation metal film 60 as a seed layer, the p-side interconnect layer 21 and the n-side interconnect layer 22 are formed.

The p-side interconnect layer 21 is also formed inside the first opening 18a and electrically connected to the p-side electrode 16. The n-side interconnect layer 22 is also formed inside the second opening 18b and electrically connected to the n-side electrode 17.

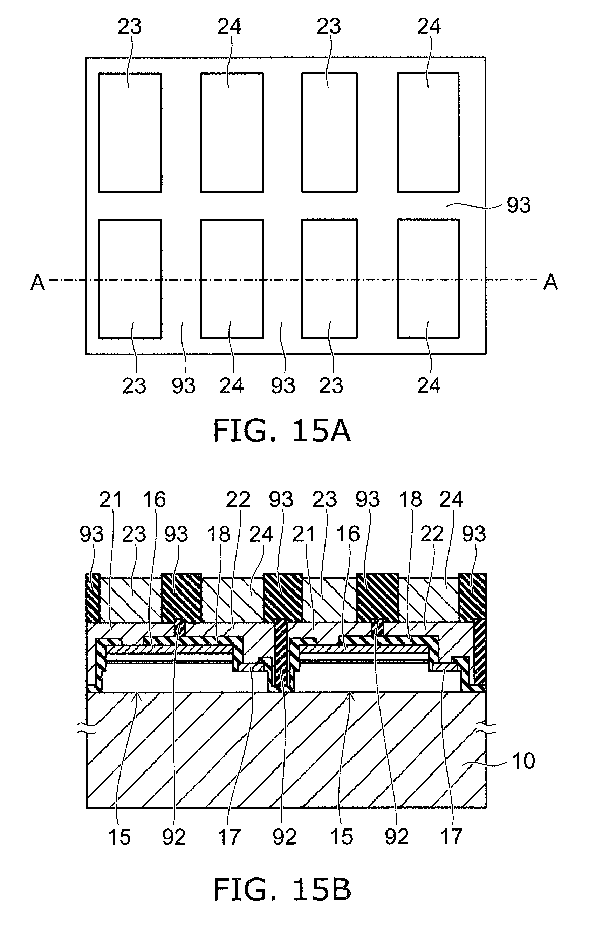

After forming the p-side interconnect layer 21 and the n-side interconnect layer 22, on these interconnect layers 21 and 22, a resist mask 93 is selectively formed as shown in FIGS. 15A and 15B. Thereafter, by an electrolytic copper plating method using the p-side interconnect layer 21 and the n-side interconnect layer 22 as seed layers, the p-side metal pillar 23 and the n-side metal pillar 24 are formed.

The p-side metal pillar 23 is formed on the p-side interconnect layer 21. The p-side interconnect layer 21 and the p-side metal pillar 23 are integrated with the same copper material. The n-side metal pillar 24 is formed on the n-side interconnect layer 22. The n-side interconnect layer 22 and the n-side metal pillar 24 are integrated with the same copper material.

The resist masks 92 and 93 are removed by using, for example, a solvent or oxygen plasma.

At this time point, the p-side interconnect layer 21 and the n-side interconnect layer 22 are connected to each other through the foundation metal film 60. Then, the foundation metal film 60 between the p-side interconnect layer 21 and the n-side interconnect layer 22 is removed by etching. By doing this, the electrical connection between the p-side interconnect layer 21 and the n-side interconnect layer 22 is disconnected.

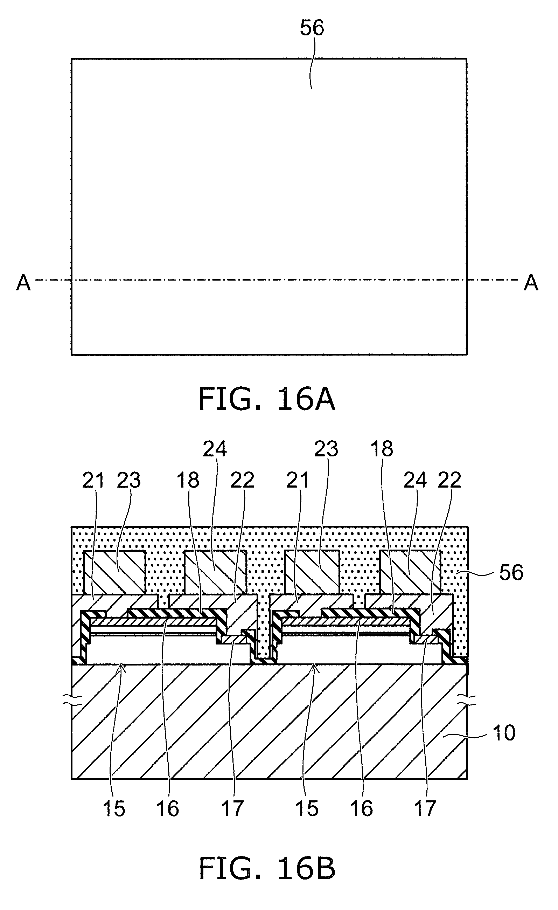

Subsequently, on the structure body obtained by the above-described steps, as shown in FIGS. 16A and 16B, the above-described composite resin 56 (resin layer) is formed. The composite resin 56 covers the p-side interconnect unit 41 and the n-side interconnect unit 43. The composite resin 56 is formed by, for example, a screen printing method, a compression-molding method, or the like.

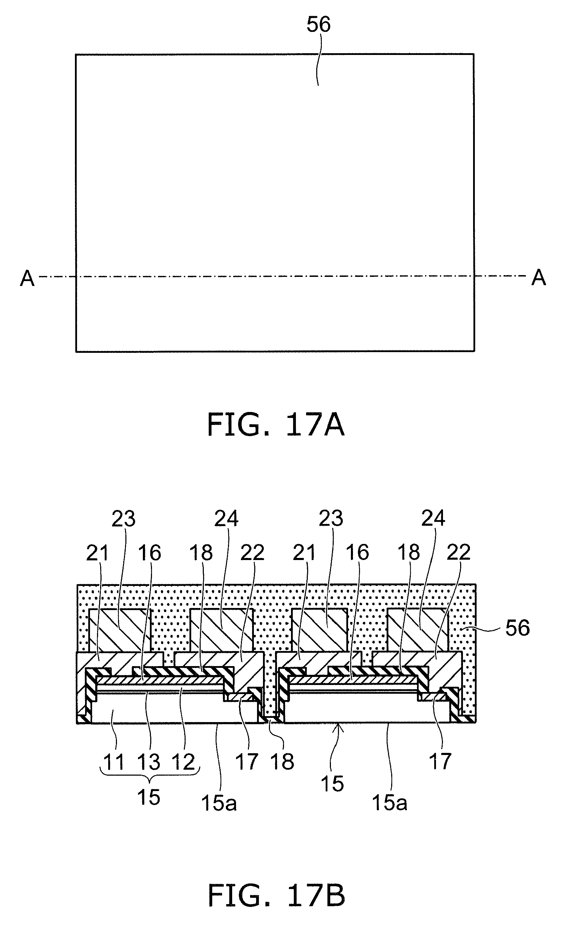

The composite resin 56 constitutes the support 100 along with the p-side interconnect unit 41 and the n-side interconnect unit 43. In a state where the semiconductor layer 15 is supported by the support 100, the substrate 10 is removed as shown in FIGS. 17A and 17B.

For example, the substrate 10 which is a silicon substrate is removed by wet etching. Alternatively, in the case where the substrate 10 is a sapphire substrate, the substrate 10 can be removed by a laser lift-off method.

The semiconductor layer 15 epitaxially grown on the substrate 10 sometime has a large internal stress. Further, the p-side metal pillar 23, the n-side metal pillar 24, and the composite resin 56 are softer materials as compared with the semiconductor layer 15 which is, for example, a GaN-based material. Therefore, even if the internal stress during the epitaxial growth is released all at once when the substrate 10 is detached, the p-side metal pillar 23, the n-side metal pillar 24, and the composite resin 56 absorb the stress. Due to this, the breakage of the semiconductor layer 15 during the process of removing the substrate 10 can be avoided.

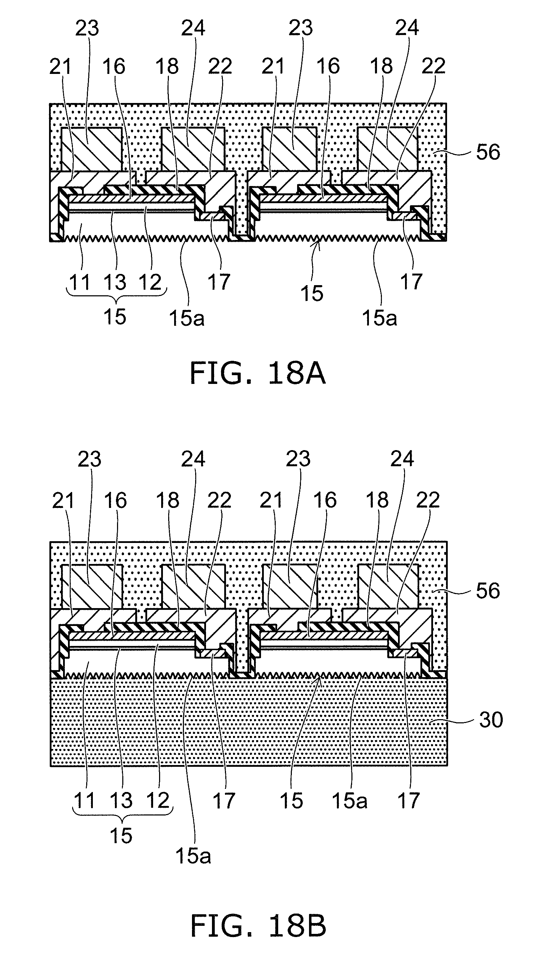

By removing the substrate 10, the first face 15a of the semiconductor layer 15 is exposed. On the exposed first face 15a, as shown in FIG. 18A, fine irregularities are formed. For example, the first face 15a is wet-etched with an aqueous solution of KOH (potassium hydroxide), TMAH (tetramethylammonium hydroxide), or the like. In this etching, a difference in etching speed occurs according to the crystal plane orientation. Due to this, irregularities can be formed on the first face 15a. By forming irregularities on the first face 15a, the extraction efficiency of the emitted light from the light emitting layer 13 can be improved.

Alternatively, fine irregularities may be formed on the first face 15a by etching using a resist film formed by lithography as a mask.

On the first face 15a, as shown in FIG. 18B, the phosphor layer 30 is formed through an insulating film (not shown). The phosphor layer 30 is formed by, for example, a method such as screen printing, potting, molding, or compression-molding. Alternatively, the phosphor layer 30 in the form of a film is attached to the first face 15a through an insulating film (not shown). Incidentally, the insulating film between the first face 15a and the phosphor layer 30 may be omitted as needed.

After forming the phosphor layer 30, a surface (an upper surface in FIG. 19B) of the composite resin 56 is ground by, for example, a backside grinder or the like, and as shown in FIG. 19A, the p-side metal pillar 23 and the n-side metal pillar 24 are exposed from the composite resin 56. The exposed surface of the p-side metal pillar 23 becomes the p-side external terminal 23a, and the exposed surface of the n-side metal pillar 24 becomes the n-side external terminal 24a.

Subsequently, in a region where the above-described groove 91 for dividing the semiconductor layer 15 into a plurality of regions is formed, as shown in FIGS. 20A and 20B, the wafer is diced. That is, the phosphor layer 30, the insulating film 18, and the composite resin 56 are cut. These members are cut by, for example, a dicing blade or a laser light. The semiconductor layer 15 is not present in a diced region, and therefore is not damaged by the dicing.

The above-described respective processes before dicing into individual pieces are carried out in a wafer state including a lot of semiconductor layers 15. The wafer is diced into individual pieces as semiconductor light emitting devices, each of which includes at least one semiconductor layer 15. Incidentally, the semiconductor light emitting device may have a single-chip structure including one semiconductor layer 15, or may have a multi-chip structure including the plurality of semiconductor layers 15.

Since the above-described respective processes before dicing into individual pieces are carried out collectively in a wafer state, it is not necessary to perform the formation of interconnect layers, the formation of pillars, the packaging with a resin layer, and the formation of a phosphor layer for each of the diced individual devices, and therefore, it becomes possible to greatly reduce the cost.

After forming the support 100 and the phosphor layer 30 in a wafer state, these members are cut, and therefore, the side surface of the phosphor layer 30 and the side surface of the support 100 (the side surface of the composite resin 56) are aligned, and these side surfaces form the side surface of the diced individual semiconductor light emitting devices. Accordingly, a small semiconductor light emitting device having a chip-size package structure can be provided in cooperation with the configuration that the substrate 10 is not present.

FIGS. 26 to 30 are enlarged schematic cross-sectional views on the mounting surface (a surface in which the p-side external terminal 23a and the n-side external terminal 24a are provided) side of the composite resin 56 in the semiconductor light emitting device 1 of the first embodiment.

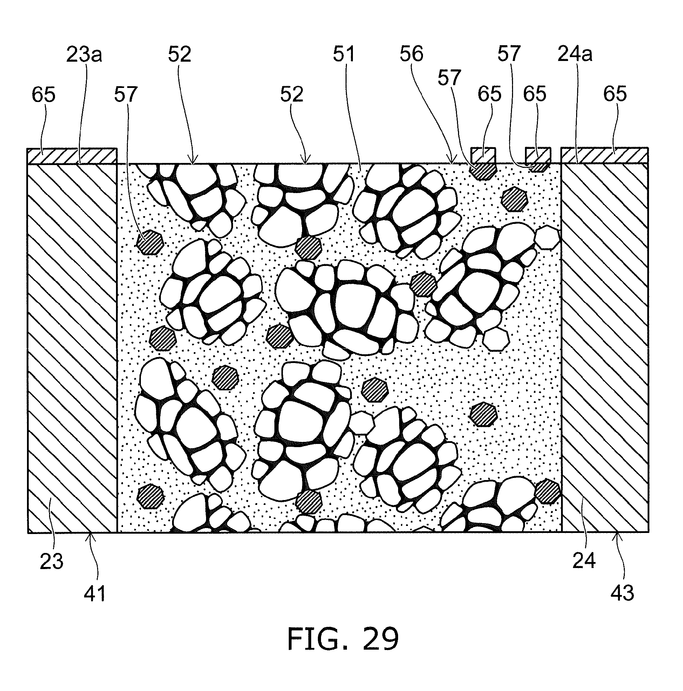

As the second powder body 57, for example, a metal such as copper is used. On the other hand, also on the surfaces of the p-side external terminal 23a and the n-side external terminal 24a, for example, a metal such as copper is used. In general, copper is known to be naturally oxidized to deteriorate the wettability to a solder, and as the measures therefor, for example, covering may be sometimes performed with a metal film 65 of gold or the like by electroless plating. However, at this time, when the second powder body 57 is exposed on the mounting surface side, as shown in FIG. 29, also the surface of the second powder body is covered with the metal film 65 by electroless plating. Since gold has high wettability to a solder, as shown in FIG. 29, if the second powder body 57 is scattered between the external terminal 23a and the external terminal 24a on the mounting surface side, there is a concern that the solder may form a bridge therebetween to cause a short-circuit defect.

Therefore, after polishing the composite resin 56 in a process shown in FIG. 19B, the second powder body 57 exposed on the surface of the composite resin 56 is removed by etching.

FIG. 26 shows a state after the second powder body 57 is removed by etching, and a void 62h is formed in a portion where the second powder body 57 is removed.

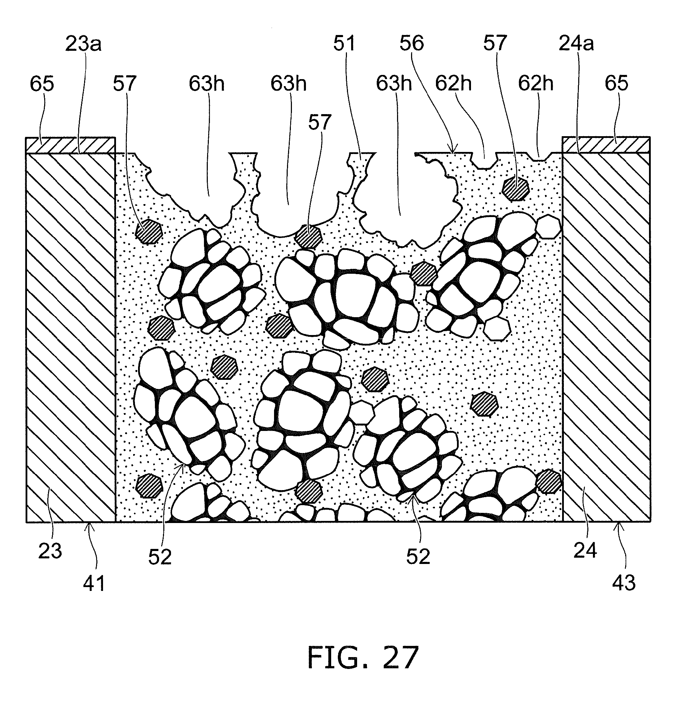

Alternatively, as described above, the metal film 65 can be formed also on the surface of the first powder body 52 by electroless plating. If a metal film is formed on the exposed surface of the first powder body 52 on the mounting surface side, a solder is liable to be wet, so that a bridge defect can be caused, and therefore, as shown in FIG. 27, the first powder body 52 exposed on the surface of the composite resin 56 may be removed by etching. A void 63h is formed in a portion where the first powder body 52 is removed.

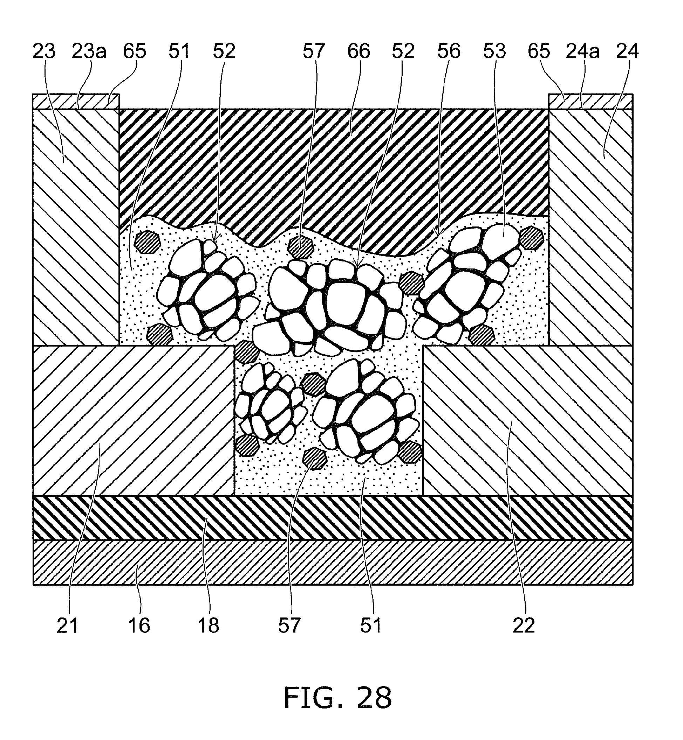

Alternatively, as shown in FIG. 28, a resin 66 is stacked on the composite resin 56, and the surface of the composite resin 56 may be covered with the resin 66. The resin 66 is a common insulating resin with no varistor characteristic. In the case where a resin system whose volumetric shrinkage at the time of curing is increased is used as the resin component 51 of the composite resin 56, on an upper surface (a boundary surface between the composite resin 56 and the resin 66) of the composite resin 56, gentle irregularities are formed.

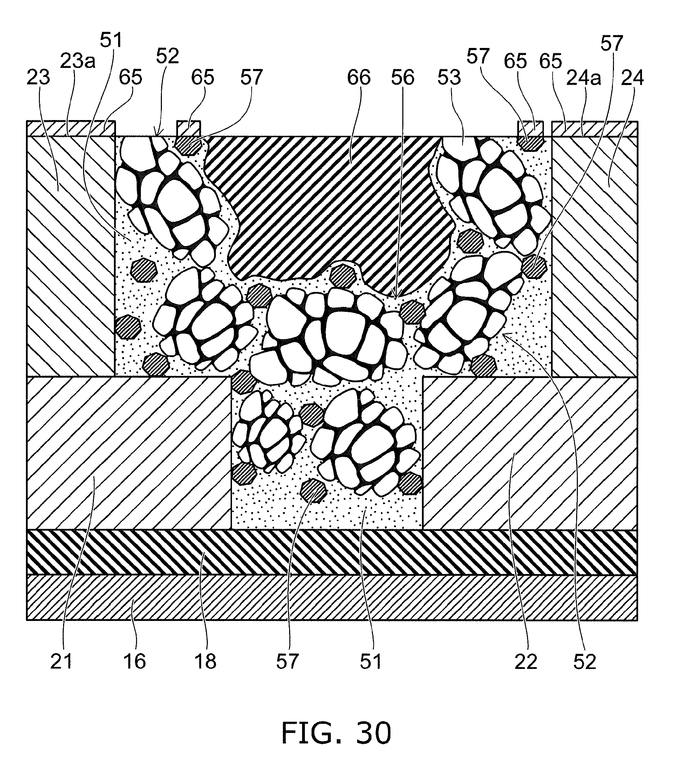

Further, as shown in FIG. 30, it does not matter if the composite resin 56 is formed also on the side surfaces of the p-side metal pillar 23 and the n-side metal pillar 24.

After forming the p-side metal pillar 23 and the n-side metal pillar 24 shown in FIG. 15, the resist masks 93 and 92 are removed, and the foundation metal film 60 (seed film) which is not shown in the drawing is removed by removing a portion immediately below the p-side interconnect layer 21 and the n-side interconnect layer 22. Thereafter, the composite resin 56 is formed on the surfaces of the passivation film (insulating film) 18, the p-side interconnect layer 21, the n-side interconnect layer 22, the p-side metal pillar 23, and the n-side metal pillar 24, and the resin 66 is formed thereon. Thereafter, the resin 66 is ground until the p-side metal pillar 23 and the n-side metal pillar 24 are exposed, followed by electroless plating, whereby a configuration shown in FIG. 30 can be obtained. The resin 66 is a common insulating resin with no varistor characteristic.

In the case of the structure shown in FIG. 30, the second powder body 57 or the powder body 52 in the composite resin 56 may be exposed in the outer peripheral portions of the p-side external terminal 23a and the n-side external terminal 24a, however, even if the exposed surfaces are covered with the metal film 65, the p-side external terminal 23a and the n-side external terminal 24a are separated from each other by the resin 66, and therefore, the structure hardly causes a short-circuit defect.

In the case of adopting the structures shown in FIGS. 28 and 30, since the composite resin 56 is used only partially, it becomes possible to make the warpage or the like of a device or a wafer proper by adjusting the mechanical properties of the common resin 66. That is, the composite resin 56 can optimize the electric properties even at the expense of somewhat the mechanical properties, and thus, a higher-performance device can be realized.

For example, in the case where a resin system whose volumetric shrinkage at the time of curing is large is used as the resin component 51 constituting the composite resin 56, a device or a wafer may be largely warped when adopting, for example, the structure as shown in FIG. 26, however, when adopting the structures shown in FIGS. 28 and 30, the warpage may be able to be adjusted to be small by the property of the resin 66. If the curing shrinkage ratio of the resin component 51 constituting the composite resin 56 can be made large, the ratio of the resin component 51 in the composite resin 56 after curing is decreased, so that the ratio of the powder body 52 and the second powder body 57 is relatively increased, and thus, the probability of contact between the powder bodies or between the metal portions 21, 22, 23, or 24 of the device and the powder body is increased, whereby a surge bypass path can be formed more in the composite resin 56 to enhance the electric properties.

Further, in the case of adopting the structures shown in FIGS. 28 and 30, the formation of the composite resin 56 may be performed so that the composite resin 56 is relatively thin before stacking the resin 66. Accordingly, for example, even if the resin component 51 contains a solvent, the solvent can be easily vaporized during curing, and therefore, it is possible to avoid the occurrence of a problem such as the formation of air bubbles inside the composite resin 56. In general, in the case of a resin containing a solvent, the solvent is removed during curing, and therefore, the volumetric shrinkage is known to be increased by that much. As a result, as described above, the relative ratio of the resin component 51 after curing is decreased, so that a surge bypass path can be formed more in the composite resin 56.

Further, immediately before applying the composite resin 56 or after applying it, before curing it or during curing it, a light having an energy not lower than a band gap of the semiconductor layer 15, for example, a blue light, a bluish purple light, a purple light, an ultraviolet light, or the like with a wavelength of 450 nm or less may be irradiated onto the semiconductor layer 15. By doing this, a photovoltaic power is generated in the semiconductor layer 15, and a potential difference occurs between the p-side interconnect layer 21 and the n-side interconnect layer 22. By this potential difference, the first powder body 52 having a varistor characteristic is attracted, and a bridge path can be formed more densely between the p-side interconnect layer 21 and the n-side interconnect layer 22.

In particular, in the case where the growth substrate 10 has a light transmission property such as sapphire or SiC, even after applying the composite resin 56, it is possible to irradiate a light from the growth substrate 10 side. Further, the method for causing a potential difference between the p-side interconnect layer 21 and the n-side interconnect layer 22 is not limited to light irradiation, and a method in which a voltage is applied by probing the p-side metal pillar 23 and the n-side metal pillar 24 may be adopted.

Next, a description will be made by showing a semiconductor device having an IC (Integrated Circuit) as one example of the electronic device.

### (Second Embodiment)

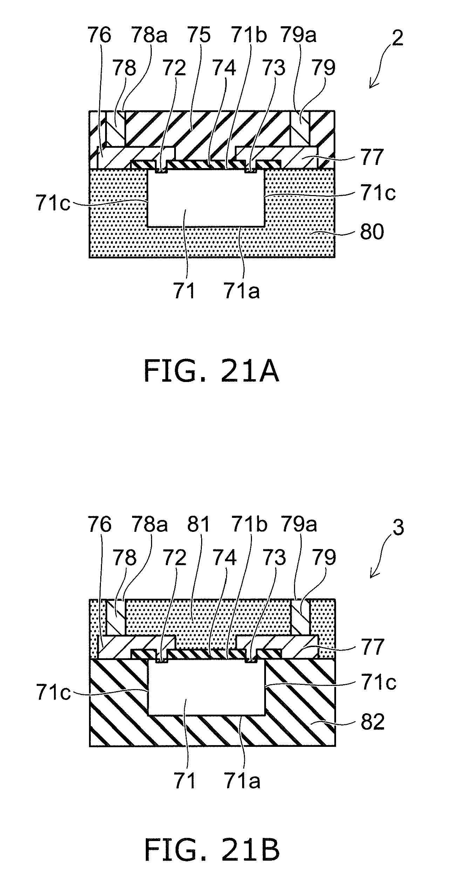

FIG. 21A is a schematic cross-sectional view of a semiconductor device 2 of a second embodiment.

The semiconductor device 2 includes a semiconductor layer (semiconductor chip) 71. The semiconductor layer 71 has a first face 71a and a second face 71b on an opposite side thereof.

On the second face 71b, the plurality of first electrodes 72 and the plurality of second electrodes 73 are provided.

On the side of a first face 71a and a side surface 71c of the semiconductor layer 71, a resin layer 80 is provided. The resin layer 80 covers the first face 71a and the side surface 71c of the semiconductor layer 71.

On the second face 71b of the semiconductor layer 71, an insulating film 74 is provided. The insulating film 74 is also provided on a portion of the surface of the resin layer 80 provided on a periphery of the side surface 71c of the semiconductor layer 71.

On the insulating film 74, and also on the resin layer 80 on the periphery of the side surface 71c of the semiconductor layer 71, a first interconnect layer 76 and a second interconnect layer 77 are provided spaced apart from each other.

The first interconnect layer 76 is connected to the first electrode 72 through a via passing through the insulating film 74. The second interconnect layer 77 is connected to the second electrode 73 through a via passing through the insulating film 74.

On the first interconnect layer 76, a first metal pillar 78 which is thicker than the first interconnect layer 76 is provided. The first interconnect layer 76 and the first metal pillar 78 form a first interconnect unit electrically connected to the first electrode 72.

On the second interconnect layer 77, a second metal pillar 79 which is thicker than the second interconnect layer 77 is provided. The second interconnect layer 77 and the second metal pillar 79 form a second interconnect unit electrically connected to the second electrode 73.

On the insulating film 74, on the resin layer 80, on the first interconnect layer 76, and on the second interconnect layer 77, a resin layer 75 is provided. The resin layer 75 is provided on a side surface of the first interconnect layer 76, a side surface of the second interconnect layer 77, a side surface of the first metal pillar 78, and a side surface of the second metal pillar 79. Between the first interconnect layer 76 and the second interconnect layer 77, the resin layer 75 is filled. Between the first metal pillar 78 and the second metal pillar 79, the resin layer 75 is filled.

An end portion 78a exposed from the resin layer 75 of the first metal pillar 78 functions as an external terminal which can be connected to an external circuit such as a mounting substrate. An end portion 79a exposed from the resin layer 75 of the second metal pillar 79 functions as an external terminal which can be connected to an external circuit such as a mounting substrate. These external terminals are, for example, bonded to a land pattern of the mounting substrate through, for example, a solder or a conductive bonding material.

A plane size of each of the external terminals is larger than a plane size of each of the chip electrodes 72 and 73, and a pitch between the external terminals is larger than a pitch between the electrodes 72, a pitch between the electrodes 73, and a pitch between the electrodes 72 and 73.

According to the semiconductor device 2 of the second embodiment, the resin layer 80 which seals the first face 71a and the side surface 71c of the semiconductor layer 71 contains the above-described composite resin 56 of the first embodiment.

The first interconnect layer 76 and the second interconnect layer 77 are in contact with the resin layer 80 having a varistor characteristic in a peripheral region of the side surface 71c of the semiconductor layer 71.

Therefore, between the end portion 78a of the first interconnect unit and the end portion 79a of the second interconnect unit which can be exposed to the outside in a state before mounting, the semiconductor layer 71 and the first powder body 52 of the composite resin are connected in parallel to each other, and the first powder body 52 functions as a protective element which protects the semiconductor layer 71 from a surge voltage. A surge current can flow between the first interconnect unit and the second interconnect unit through the first powder body 52 without passing through the semiconductor layer 71.

At the time of a normal operation in which a power supply voltage of a rated voltage or less is applied between the first interconnect unit and the second interconnect unit, the first powder body 52 is in a high-resistance state due to a Schottky-barrier in the vicinity of the grain boundary 54, and therefore, a short circuit between the first interconnect unit and the second interconnect unit does not occur through the first powder body 52.

According to the second embodiment, an ESD protective element to be externally connected to the semiconductor device 2 is not needed. Due to this, the semiconductor device 2 having excellent electrostatic resistance can be provided without hindering miniaturization. Further, an I/O (input/output) load capacity is decreased, and therefore, a high-speed operation can be achieved.

Further, the second embodiment can be applied not only to an IC, but also to an MEMS (Micro Electro Mechanical Systems) element and an RF (Radio Frequency) element. In the RF element, when an ESD protective element is no longer needed by making a sealing resin to have a varistor characteristic, it is also possible to decrease the parasitic capacitance of an RF signal line.

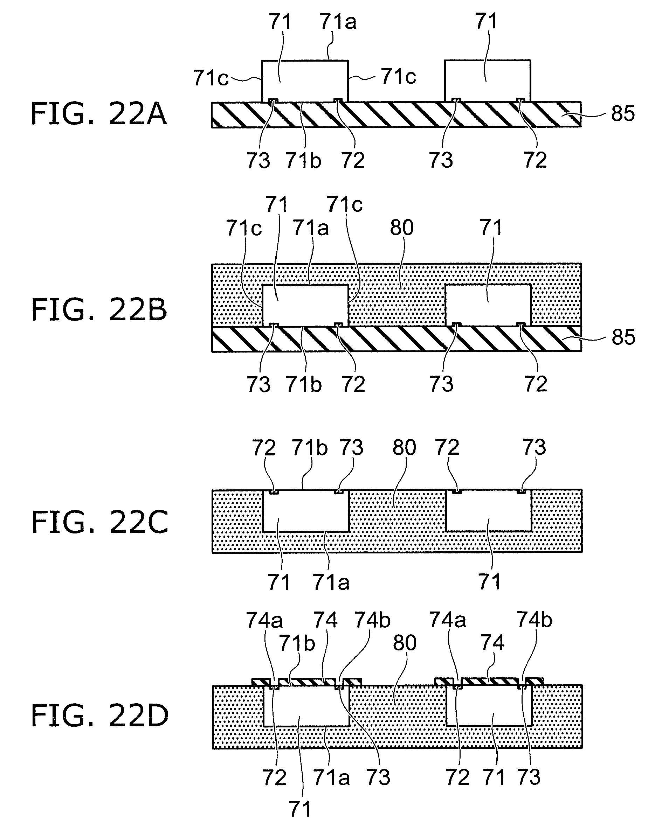

FIGS. 22A to 23C are schematic cross-sectional views showing a manufacturing method for the semiconductor device 2 of the second embodiment.

As shown in FIG. 22A, a plurality of chip-shaped semiconductor layers 71 is arranged spaced apart from one another on a heat-resistant film 85. The semiconductor layers 71 on the side of the second face 71b having the electrodes 72 and 73 formed thereon are attached to the heat-resistant film 85.

Subsequently, as shown in FIG. 22B, on the heat-resistant film 85, the resin layer 80 containing the above-described composite resin having a varistor characteristic is formed. The first face 71a and the side surface 71c of the semiconductor layer 71 are covered with the resin layer 80. The resin layer 80 is also filled between the plurality of semiconductor layers 71.

Subsequently, the heat-resistant film 85 is detached. FIG. 22C shows a state in which the heat-resistant film 85 is detached, and the resin layer 80 which seals the plurality of semiconductor layers 71 is turned over. For example, the resin component on the second face 71b and the electrodes 72 and 73 is removed by ashing.

Subsequently, on the surface of the resin layer 80 on the second face 71b, the insulating film 74 is formed, and thereafter, as shown in FIG. 22D, the insulating film 74 is patterned. In the insulating film 74, an opening 74a which reaches the first electrode 72 and an opening 74b which reaches the second electrode 73 are formed.

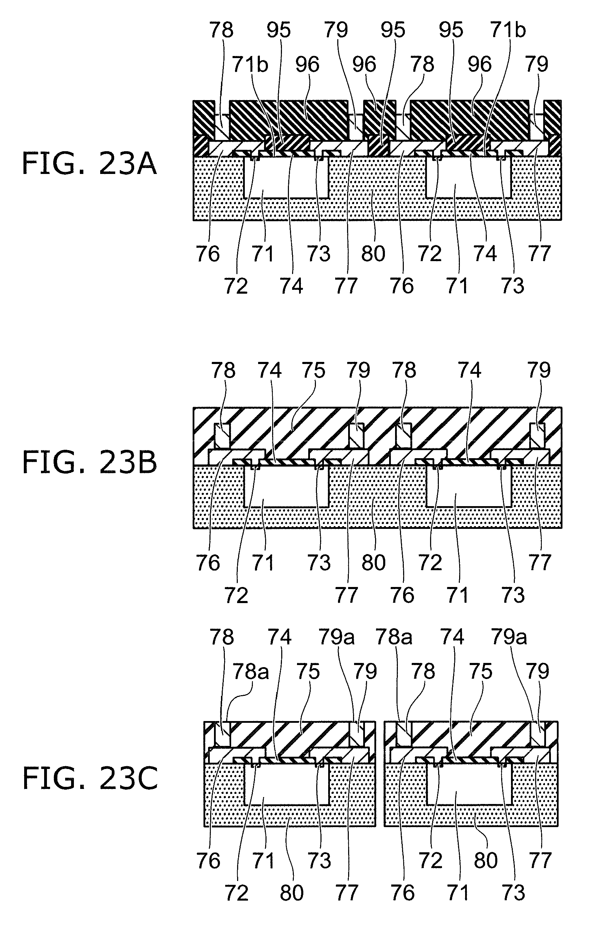

Subsequently, a metal film (not shown) is formed, and thereafter, as shown in FIG. 23A, a resist mask 95 is formed, and the first interconnect layer 76 and the second interconnect layer 77 are formed on the second face 71b side by a plating method. The first interconnect layer 76 is connected to the first electrode 72 through the opening 74a (FIG. 22D). The second interconnect layer 77 is connected to the second electrode 73 through the opening 74b (FIG. 22D).

Further, a resist mask 96 is formed, and by a plating method, the first metal pillar 78 is formed on the first interconnect layer 76 and the second metal pillar 79 is formed on the second interconnect layer 77.

Thereafter, the resist masks 95 and 96 are removed, and as shown in FIG. 23B, the resin layer 75 is formed. The resin layer 75 covers the insulating film 74, the first interconnect layer 76, the second interconnect layer 77, the first metal pillar 78, the second metal pillar 79, and the resin layer 80.

Thereafter, a surface of the resin layer 75 is ground, and as shown in FIG. 23C, the end portion 78a of the first metal pillar 78 and the end portion 79a of the second metal pillar 79 are exposed from the resin layer 75. Further, the resulting material is diced into individual the plurality of semiconductor devices by cutting the resin layer 80 and the resin layer 75. Incidentally, one semiconductor device may have a multi-chip structure including plurality of semiconductor layers 71.

Further, in the second embodiment, as shown in FIG. 21B, the resin layer 81 which seals the interconnect unit side may be configured to contain the above-described composite resin having a varistor characteristic. The first face 71a and the side surface 71c of the semiconductor layer 71 are sealed by a resin layer 82 with no varistor characteristic.

### (Third Embodiment)

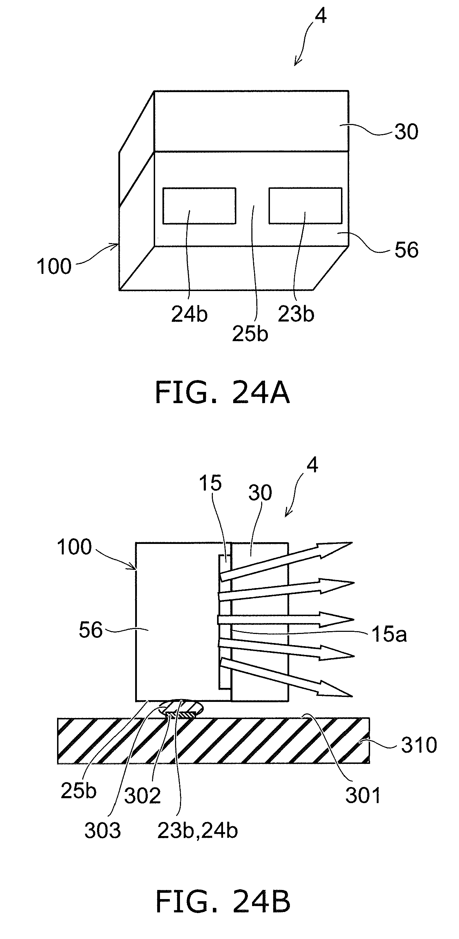

The composite resin having a varistor characteristic described above can also be applied to a side-view type semiconductor light emitting device 4 shown in FIGS. 24A and 24B.

The semiconductor light emitting device 4 of the third embodiment is different from the first embodiment in the exposed surfaces of the metal pillars 23 and 24 which are exposed from the resin layer 56 and are in charge of connection to the outside. The other configuration is the same as that of the semiconductor light emitting device of the first embodiment.

FIG. 24A is a schematic perspective view of the semiconductor light emitting device 4 of the third embodiment.

FIG. 24B is a schematic cross-sectional view of a light emitting module having a configuration in which the semiconductor light emitting device 4 of the third embodiment is mounted on a mounting substrate 310.

A part of a side surface of the p-side metal pillar 23 is a third face 25b having a plane orientation different from a first face 15a of a semiconductor layer 15 and a second face 15b on an opposite side thereof, and is exposed from the resin layer 56. The exposed surface functions as a p-side external terminal 23b for mounting on the external mounting substrate 310.

For example, the third face 25b is a face substantially perpendicular to the first face 15a and the second face 15b of the semiconductor layer 15. The resin layer 56 has, for example, four rectangular side surfaces, and one side surface among these is the third face 25b.

In the same third face 25b, a portion of the side surface of the n-side metal pillar 24 is exposed from the resin layer 56. The exposed surface functions as an n-side external terminal 24b for mounting on the external mounting substrate 310.

In the p-side metal pillar 23, a portion other than the p-side external terminal 23b exposed on the third face 25b is covered with the resin layer 56. Further, in the n-side metal pillar 24, a portion other than the n-side external terminal 24b exposed on the third face 25b is covered with the resin layer 56.

As shown in FIG, 24B, the semiconductor light emitting device 4 is mounted in a posture in which the third face 25b faces a mounting surface 301 of the substrate 310. Each of the p-side external terminal 23b and the n-side external terminal 24b exposed on the third face 25b is bonded to a pad 302 provided on the mounting surface 301 through a solder 303. On the mounting surface 301 of the substrate 310, for example, a interconnect pattern to be connected to an external circuit is provided, and the pad 302 is connected to the interconnect pattern.

The third face 25b is substantially perpendicular to the first face 15a, which is a main light emitting face. Therefore, the first face 15a faces in a lateral direction parallel to the mounting surface 301 or in an inclined direction with respect to the mounting surface 301 in a posture in which the third face 25b faces on the mounting surface 301 side. That is, the semiconductor light emitting device 4 is a so-called side-view type semiconductor light emitting device, and emits a light in a lateral direction parallel to the mounting surface 301 or in an inclined direction with respect to the mounting surface 301.

In the semiconductor light emitting device 4, in the same manner as the first embodiment, a resin layer 56 which forms a support 100 along with interconnect units 41 and 43 contains a composite resin having a varistor characteristic.

Therefore, also in the third embodiment, the semiconductor light emitting device 4 having excellent electrostatic resistance can be provided without hindering miniaturization of the semiconductor light emitting device 4 having a chip-size package structure.

In the semiconductor light emitting devices according to the first and third embodiments, the optical layer provided on the first face 15a side of the semiconductor layer 15 is not limited to the phosphor layer, and may be a scattering layer. The scattering layer contains multiple scattering materials (for example, a titanium compound) in the form of particles for scattering an emitted light from the light emitting layer 13, and a binder (for example, a resin layer) for integrating the multiple scattering materials and transmitting the emitted light from the light emitting layer 13.

### (Fourth Embodiment)

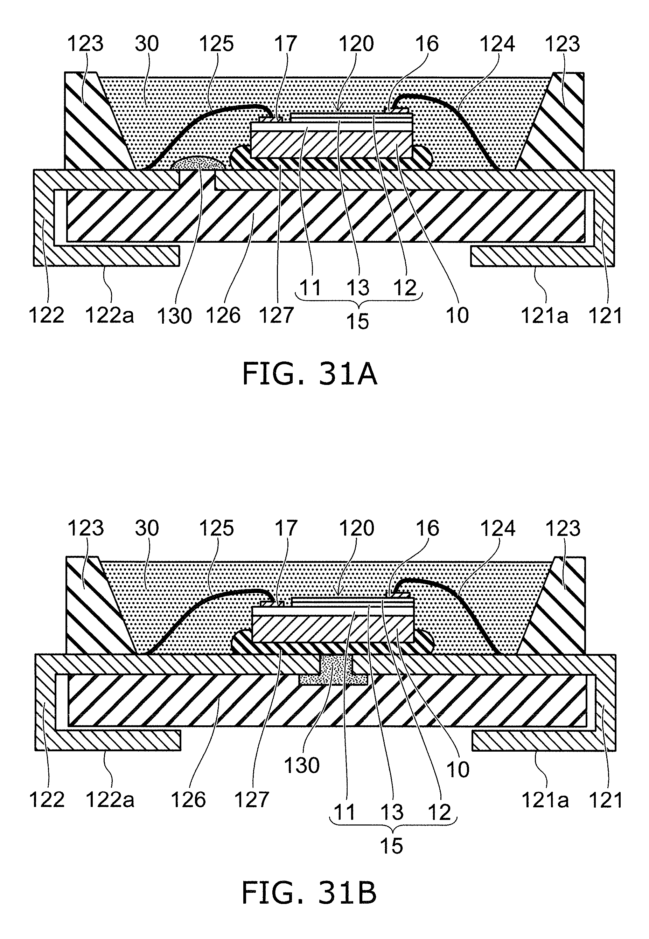

The composite resin having a varistor characteristic described above can also be applied to a surface-mounting type semiconductor light emitting device shown in FIGS. 31A and 31B.

An LED chip 120 is supported by a package obtained by integrally molding a lead frame (first interconnect unit) 121, a lead frame (second interconnect unit) 122, and resins 126 and 123. The resins 126 and 123 are each a white resin having a reflection property with respect to an emitted light from the LED chip 120 and a phosphor. The resin 123 is provided on the lead frames 121 and 122, and surrounds a periphery of the LED chip 120.

The LED chip 120 includes a semiconductor layer 15 and a substrate (for example, a sapphire substrate) 10 used for epitaxial growth of the semiconductor layer 15. The semiconductor layer 15 includes, for example, a first semiconductor layer 11 containing n-type GaN, a second semiconductor layer 12 containing p-type GaN, and a light emitting layer (active layer) 13 provided between the first semiconductor layer 11 and the second semiconductor layer 12.

The LED chip 120 is mounted such that the substrate 10 faces on the lead frame 121 side. On the substrate 10, the first semiconductor layer 11 is provided, and on the first semiconductor layer 11, a stacked film of the light emitting layer 13 and the second semiconductor layer 12 is provided. On the first semiconductor layer 11, an n-side electrode 17 is provided, and on the second semiconductor layer 12, a p-side electrode is provided. Further, on an upper surface of the second semiconductor layer 12, a transparent electrode connected to the p-side electrode 16 is provided.

The LED chip 120 is mounted on the lead frame 121 through an adhesive 127. The p-side electrode 16 is connected to the lead frame 121 through a wire 124. The n-side electrode 17 is connected to the lead frame 122 through a wire 125. The lead frame 121 and the lead frame 122 are insulated and separated from each other by a resin 126.

On a rear surface of the lead frame 121, a p-side external terminal 121a is formed, and on a rear surface of the lead frame 122, an n-side external terminal 122a is formed. The p-side external terminal 121a and the n-side external terminal 122a are bonded to a circuit board through, for example, a solder.

In a region surrounded by the resin 123 on the upper side of the lead frames 121 and 122, a phosphor layer 30 is provided so as to cover the LED chip 120.

FIG. 31A shows an embodiment in which a composite resin 130 is formed so as to bridge the p-side lead frame 121 and the n-side lead frame 122. The composite resin 130 has a varistor characteristic in the same manner as the above-described embodiments. The composite resin 130 is formed on an upper surface side (the phosphor layer 30 side) of the lead frames 121 and 122. This configuration can be manufactured by dispensing the composite resin 130 before and after a process of mounting the LED chip 120.

Also in FIG. 31B, the composite resin 130 is formed so as to bridge the p-side lead frame 121 and the n-side lead frame 122. The composite resin 130 is formed on the resin 126 (white resin) side. This configuration can be manufactured by forming the composite resin 130 after forming the lead frames 121 and 122, followed by molding the resin 126 by injection molding or the like. If a reflective resin is used as the adhesive 127, the composite resin 130 is hidden on a rear side of the adhesive 127, and therefore, an optical loss can be avoided.

Incidentally, here, the composite resin 130 contains a powder having a varistor characteristic, and the powder is a polycrystalline powder body obtained by aggregating primary particles containing, for example, zinc oxide as a main component and having a semiconductor of a wurtzite crystal structure. The primary particles are aggregated through a grain boundary containing, for example, bismuth or praseodymium at a high concentration. Further, the size of the primary particle is smaller than a gap (minimum distance) between the p-side lead frame (first interconnect unit) 121 and the n-side lead frame (second interconnect unit) 122.

Although several embodiments of the invention have been described, these embodiments are presented as examples only, and are not intended to limit the scope of the invention. These novel embodiments can be practiced in a variety of other forms, and various omissions, substitutions, and changes can be made without departing from the gist of the invention. These embodiments and their modifications are included in the scope and gist of the invention, and are also included in the range of the inventions described in the scope of the claims and their equivalents.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A composite resin comprising:
a resin component (51);
a plurality of first powder bodies (52) dispersed in the resin component (51), and having a nonlinear current-voltage characteristic having a decreasing resistance as a voltage increases; and
a plurality of second powder bodies (57) dispersed in the resin component (51), and having electrical conductivity,
the plurality of first powder bodies (52) being a polycrystalline powder body including a plurality of primary particles (53) bound via a grain boundary (54), a component different from a main component of the plurality of primary particles (53) being present, and
a work function of the plurality of second powder bodies (57) being not more than a work function of the plurality of primary particles (53).

2. The resin according to claim 1, wherein the component different from the main component of the plurality of primary particles (53) is present at a higher concentration in the grain boundary (54) than in an interior of the plurality of primary particles (53).

3. The resin according to claim 1, wherein the primary particles (53) contain zinc oxide as the main component.

4. The resin according to claim 3, wherein the primary particles (53) have a semiconductor of wurtzite crystal structure.

5. The resin according to claim 3, wherein at the grain boundary (54), an element of either bismuth or praseodymium is present at a higher concentration than in the inside of the primary particles (53).

6. The resin according to claim 3, wherein the second powder bodies (57) contain at least any of tungsten, ruthenium, rhenium, molybdenum, and chromium.

7. The resin according to claim 3, wherein the second powder bodies (57) contain at least either of ITO (indium tin oxide) and IGZO (InGaZnOx).

8. The resin according to claim 3, wherein the second powder bodies (57) contain at least any of tantalum, titanium, niobium, manganese, aluminum, and zirconium.

9. The resin according to claim 3, wherein the second powder bodies (57) contain hafnium.

10. The resin according to claim 3, wherein the second powder bodies (57) contain at least any of tin, bismuth, lead, and indium.

11. The resin according to claim 3, wherein the second powder bodies (57) contain silver.

12. The resin according to claim 3, wherein the second powder bodies (57) contain at least any of iron, silicon, antimony, boron, gallium, vanadium, zinc, magnesium, thorium, neodymium, and yttrium.

13. An electronic device comprising:
a semiconductor layer (15) having a first face (15a) and a second face, the second face being on a side opposite to the first face (15a);
a first electrode (16) provided on the semiconductor layer (15) on the second face side;
a second electrode (17) provided on the semiconductor layer (15) on the second face side and separated from the first electrode (16);
a first interconnect unit (21) connected to the first electrode (16);
a second interconnect unit (22) separated from the first interconnect unit (21) and connected to the second electrode (17); and
a composite resin (56) provided in contact with the first interconnect unit (21) and the second interconnect unit (22),
the composite resin (56) including
a resin component (51),
a plurality of first powder bodies (52) dispersed in the resin component (51), and having a nonlinear current-voltage characteristic having a decreasing resistance as a voltage increases, and
a plurality of second powder bodies (57) dispersed in the resin component (51), and having electrical conductivity,
the plurality of first powder bodies (52) being a polycrystalline powder body including a plurality of primary particles (53) bonding via a grain boundary (54), a component different from a main component of the plurality of primary particles (53) being present, and
a work function of the plurality of second powder bodies (57) being not more than a work function of the plurality of primary particles (53).

14. The device according to claim 13, wherein the component different from the main component of the plurality of primary particles (53) is present at a higher concentration in the grain boundary (54) than in an interior of the plurality of primary particles (53).

15. The device according to claim 13, wherein at least either of the first powder bodies (52) and the second powder bodies (57) are in contact with at least either of the first interconnect unit (21) and the second interconnect unit (22).

16. The device according to claim13, wherein some of the first powder bodies (52) are in contact with at least either of the first interconnect unit (21) and the second interconnect unit (22) via the second powder bodies (57).

17. The device according to claim 13, wherein the primary particles (53) contain zinc oxide as the main component.

18. The device according to claim 17, wherein the primary particles (53) have a semiconductor of a wurtzite crystal structure.

19. The device according to claiml7, wherein the primary particles (53) have a size smaller than a minimum distance between the first interconnect unit and the second interconnect unit.
